(19) **Europäisches Patentamt European Patent Office Office européen des brevets**

(11) **EP 1 970 973 B1**

(12) **EUROPEAN PATENT SPECIFICATION**

(45) Date of publication and mention
of the grant of the patent:
**09.12.2009 Bulletin 2009/50**

(51) Int Cl.:
***H01L 35/30*** *(2006.01)*

(21) Application number: **07447010.5**

(22) Date of filing: **12.02.2007**

(54) **Method for thermal matching of a thermoelectric generator with a heat source having high thermal resistance and thermoelectric generator thus obtained**

Verfahren zur thermischen Abstimmung eines thermoelektrischen Generators auf eine Wärmequelle mit hohem Wärmewiderstand und so erhaltener thermoelektrischer Generator

Procédé de correspondance thermique d'un générateur thermoélectrique avec une source de chaleur comportant une forte résistance thermale et un générateur thermoélectrique ainsi obtenu

(84) Designated Contracting States:
**AT BE BG CH CY CZ DE DK EE ES FI FR GB GR HU IE IS IT LI LT LU LV MC NL PL PT RO SE SI SK TR**

(43) Date of publication of application:
**17.09.2008 Bulletin 2008/38**

(73) Proprietor: **Interuniversitair Microelektronica Centrum Nederland 5656 AE Eindhoven (NL)**

(72) Inventor: **Leonov, Vladimir 3000 Leuven (BE)**

(74) Representative: **Bird, William Edward et al Bird Goën & Co. Klein Dalenstraat 42A 3020 Winksele (BE)**

(56) References cited:
**EP-A- 1 001 470      EP-A- 1 612 870
EP-A1- 1 227 375      US-A- 6 075 199
US-A1- 2006 243 317      US-B1- 6 222 114**

**US-B1- 6 438 964**

- **LEONOV V ET AL: "Thermoelectric mems generators as a power supply for a body area network" SOLID-STATE SENSORS, ACTUATORS AND MICROSYSTEMS, 2005. DIGEST OF TECHNICAL PAPERS. TRANSDUCERS '05. THE 13TH INTERNATIONAL CONFERENCE ON SEOUL, KOREA JUNE 5-9, 2005, PISCATAWAY, NJ, USA,IEEE, 5 June 2005 (2005-06-05), pages 291-294, XP010828018 ISBN: 0-7803-8994-8**
- **TORFS, T ET AL: "BODY-HEAT POWERED AUTONOMOUS PULSE OXIMETER" IEEE SENSORS 2006 EXCO, 22 October 2006 (2006-10-22), - 25 October 2006 (2006-10-25) pages 427-430, XP002445434 DAEGU KOREA**
- **KISHI M ET AL: "Micro thermoelectric modules and their application to wristwatches as an energy source" EIGHTEENTH INTERNATIONAL CONFERENCE ON THERMOELECTRICS. PROCEEDINGS, ICT'99 (CAT. NO.99TH8407) IEEE PISCATAWAY, NJ, USA, 1999, pages 301-307, XP010379381 ISBN: 0-7803-5451-6**
- **HASEBE S ET AL: "Polymer based smart flexible thermopile for power generation" MICRO ELECTRO MECHANICAL SYSTEMS, 2004. 17TH IEEE INTERNATIONAL CONFERENCE ON. (MEMS) MAASTRICHT, NETHERLANDS 25-29 JAN. 2004, PISCATAWAY, NJ, USA,IEEE, US, 25 January 2004 (2004-01-25), pages 689-692, XP010767983 ISBN: 0-7803-8265-X**

## Description

### Technical field of the invention

The present invention relates to thermoelectric generators (TEGs) and more specifically to TEGs operated with a heat source having a high thermal resistance, more specifically to TEGs operated under conditions of non-constant heat flow and non-constant temperature difference between hot and cold plates. More specifically, embodiments of this invention relate to a method for thermal matching of a TEG with a heat source and a heat sink in case the TEG is used on an object with high thermal resistance, e.g. on a human body or on a body of any other homeotherm, and dissipates heat into a fluid such as air. Alternatively, embodiments of this invention relate to a method for thermal matching of a TEG with a heat source an a heat sink in case the TEG receives heat from a fluid, like for example air, having a different temperature with respect to an object with high thermal resistance, e.g. a human body or a body of any other homeotherm, onto which the TEG is positioned. Furthermore this invention relates to TEGs designed according to this thermal matching method.

### Background of the invention

A thermoelectric generator (TEG) utilises a temperature difference occurring between a hot (warm) object, i.e. a heat source, and its colder surrounding, i.e. a heat sink, and is used to transform a consequent heat flow into a useful electrical power. The necessary heat can for example be produced by radioactive materials, as e.g. in space applications, or by sources available in the ambient, like e.g. standard cooling/heating systems, pipe lines including pipe lines with warm waste water, surfaces of engines, parts of machines and buildings or by homeotherms (i.e. by warm-blooded animals or human beings). Natural temperature gradients could be used as well as geothermal temperature gradients, temperature gradients on ambient objects when naturally cooling/heating at night/day, temperature differences between a liquid or a gas in a pipeline and its surrounding, heated machinery, engines, transport and ambient air, between window glass and air indoor or outdoor, etc.

There is an increasing interest in miniaturised TEGs, which could replace batteries in consumer electronic products operating at low power. For example, TEGs mounted in a wristwatch have been used to generate electricity from wasted human heat, thus providing a power source for the watch itself, see M. Kishi, H. Nemoto, T. Hamao, M. Yamamoto, S. Sudou, M. Mandai and S. Yamamoto in "Micro-Thermoelectric Modules and Their Application to Wristwatches as an Energy Source", Proceedings ICT'99 18th Int. Conference on Thermoelectrics, p.301-307, 1999 (Seiko Instruments).

Recently, MEMS technology has also been used to fabricate miniaturised TEGs, as described by M. Strasser, R. Aigner, C. Lauterbach, T.F. Sturm, M. Franosch and G. Wachutka in "Micromachined CMOS Thermoelectric Generators as On-chip Power Supply", Transducers '03. 12th International Conference on Solid State Sensors, Actuators and Microsystems, p.45-48, 2003 (Infineon Technologies); by A. Jacquot, W.L. Liu, G. Chen, J.-P. Fleurial, A. Dausher, B. Lenoir in "Fabrication and modeling of an in-plane thermoelectric micro-generator", Proceedings ICT '02. 21st International Conference on Thermoelectrics, p.561-564, 2002; and by H. Böttner, J. Numus, A. Gavrikov, G. Kühner, M. Jägle, C. Künzel, D. Eberhard, G. Plescher A. Schubert and K.-H. Schlereth in "New Thermoelectric Components using Microsystem Technologies", Journal of Microelectromechanical Systems, vol.13, no.3, p.414-420, 2004.

Recently, thin film technology has also been used to fabricate miniaturised TEGs on a thin polymer tape, as described by S. Hasebe, J. Ogawa, M. Shiozaki, T. Toriyama, S. Sugiyama, H. Ueno and K. Itoigawa in "Polymer based smart flexible thermopile for power generation", 17th IEEE Int. Conf. Micro Electro Mechanical Systems (MEMS), 2004, pp. 689-692; by I. Stark and M. Stordeur in "New micro thermoelectric devices based on bismuth telluride-type thin solid films", Proceeding of the 18th International Conference on Thermoelectrics (ICT), Baltimore, 1999, p.465-472; by Ingo Stark and P. Zhou in WO 2004/105143 A1, 02.12.2004; by Ingo Stark in US 6,958,443 and by I. Stark in "Thermal Energy Harvesting with Thermo Life®". Proceedings of International Workshop on Wearable and Implantable Body Sensor Networks (BSN'06), 2006.

In EP 1 612 870, a micromachined TEG is proposed specially suited for application on heat sources having large thermal resistance, e.g., on homeotherms. It is shown that an effective TEG for such applications must comprise a hot plate and a radiator. The design and technology for micromachined thermopiles specially suited for such applications are reported by V. Leonov, P. Fiorini, S. Sedky, T. Torfs and C. Van Hoof in "Thermoelectric MEMS generators as a power supply for a body area network", Proceedings of the 13th International Conference on Solid-State Sensors, Actuators and Microsystems (Transducers'05), 2005, pp.291-294.

TEGs can be characterised by an electrical and a thermal resistance and by both voltage and power generated per unit temperature difference between the hot and cold sides of the TEG. The relative importance of these factors depends on the specific application. In general, electrical resistance should be low and, obviously, voltage or power output should be maximised (in particular in applications with small temperature difference, i.e. a few degrees C or a few tens degrees C). If a constant temperature difference is imposed at the boundaries of the TEG, e.g. by means of hot and cold plates at fixed temperatures relative to each other, the value of thermal resistance is not crucial, because the output voltage and the output power are proportional to the temperature difference, which is fixed. Contrary thereto, if the boundary condition is a constant heat flow or a limited heat flow through the device, then the thermal resistance, on one hand, has to be large enough to generate a reasonable temperature drop over the device, but on the other hand, has to be small enough to avoid a drastical decrease in the heat flow through the TEG, for example by more than a factor of 2. The term "constant heat flow" means that in the considered range of TEG thermal resistances the heat flow through the device is constant (limited by the ambient). However, this does not mean that the heat flow stays at the same value over time in a practical application. The term "limited heat flow" means that when decreasing the thermal resistance of the TEG, the heat flow through the device increases till a certain value, at which the conditions of constant heat flow are reached. In the case of "limited heat flow" the heat flow through the device is not limited by the ambient, but for example by the thermal resistance of the TEG.

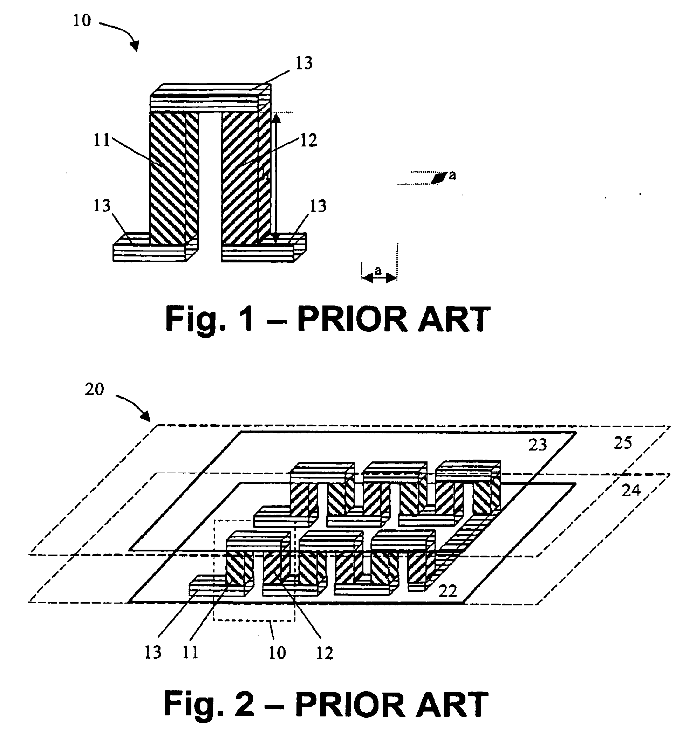

The basic element of a TEG is a thermocouple 10 (Fig. 1). An example of a thermocouple 10 for use with the present invention comprises a first leg 11 and a second leg 12 formed of two different thermoelectric materials, for example of the same but oppositely doped semiconductor material and exhibiting low thermal conductance and low electrical resistance. For example, the legs 11, 12 could be formed from BiTe. If the first leg 11 is formed of n-type BiTe, then the second leg 12 may be formed of p-type BiTe, and vice versa. The legs 11, 12 are connected by an electrically conductive interconnect, e.g. a metal layer interconnect 13, which fonns a low-resistance ohmic contact to the semiconductor legs 11, 12, thus forming a junction between the semiconductor legs 11,12.

In Fig. 2, a TEG 20 comprising a thermopile 21 comprising a plurality, preferably a large number, of thermocouples 10, is shown, wherein the junctions between legs 11, 12 are located in two planes: a hot junction plane 24 and a cold junction plane 25. The thermopile 21 is sandwiched in between a hot plate 22 and a cold plate 23. The hot plate 22 and the cold plate 23 are made of materials having a large thermal conductivity, so that the thermal conductance of the plates 22, 23 is much larger (at least a factor of 10) than the total thermal conductance of the thermopile 21.

In case of a constant or limited heat flow through the TEG 20, the output voltage and power depend on the number of thermocouples 10 comprised in it. It can easily be shown that in the case of constant heat flow, the maximum power is obtained when the heat flow through the thermoelectric material is equal to the "parasitic" heat exchange between the hot plate 22 and the cold plate 23 through the air; including radiation heat exchange.

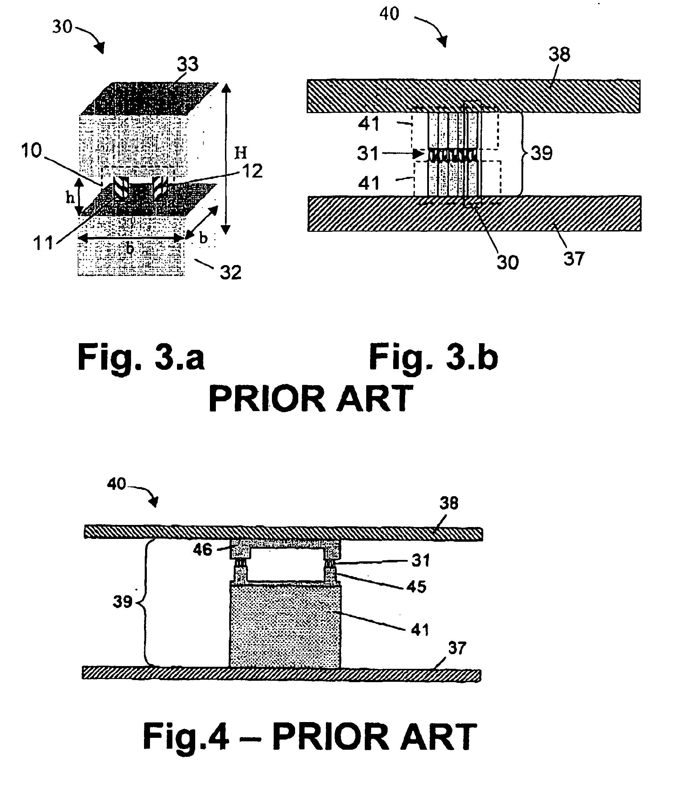

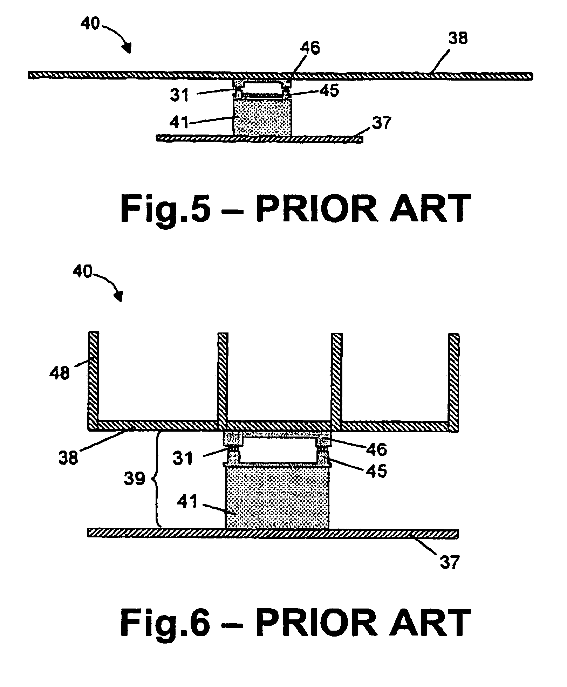

In order to give a numerical example of the above case of constant or limited heat flow, the TEG device area may be fixed to 1 $cm^2$ and the heat flow is limited by a value of 18.5 $mW/cm^2$, which is about 3 times larger than the natural heat flow from human beings to the environment at indoor conditions. Such heat flow is obtainable using the design of the TEG 40 according to EP 1 612 870, as depicted in Figs. 3 to 6, with a micromachined thermopile 31 between a hot die 45 featured with a pillar/rim structure and a cold die 46, provided with a spacer 41 to increase the distance 39 in between the two plates 37, 38. Different embodiments may be provided for the hot and cold plates 37, 38: using a large hot plate 37 and a large cold plate 38 (Fig. 4), or using a smaller hot plate 37 and a larger cold plate 38 (Fig. 5). The cold plate 38 can also be folded or shaped as a radiator 48 of more complex shapes, e.g. as shown in Fig.6 for a multi-fin radiator case. Furthermore, in the numerical example, it is assumed that the legs 11, 12 of the thermocouples 10 are made of respectively n- and p-type BiTe, and that the TEG 20 operates in air. The thermal resistance of the metal layer interconnect 13 and the electrical resistance of the contacts between the legs 11, 12 of the thermocouple 10 and the metal layer interconnect 13 are considered to be negligible. Values used for the calculations of TEG performance in the numerical example are reported in Table I herein below:

Table I

| | |
|---|---|
| Thermal conductivity of BiTe, W $m^{-1}$ $K^{-1}$ | 1.5 |
| Thermal conductivity of air, W $m^{-1}$ $K^{-1}$ | 0.026 |
| Resistivity of BiTe (n and p), $\Omega$ m | $10^{-5}$ |
| Input heat flow, W $m^{-2}$ | 185 |

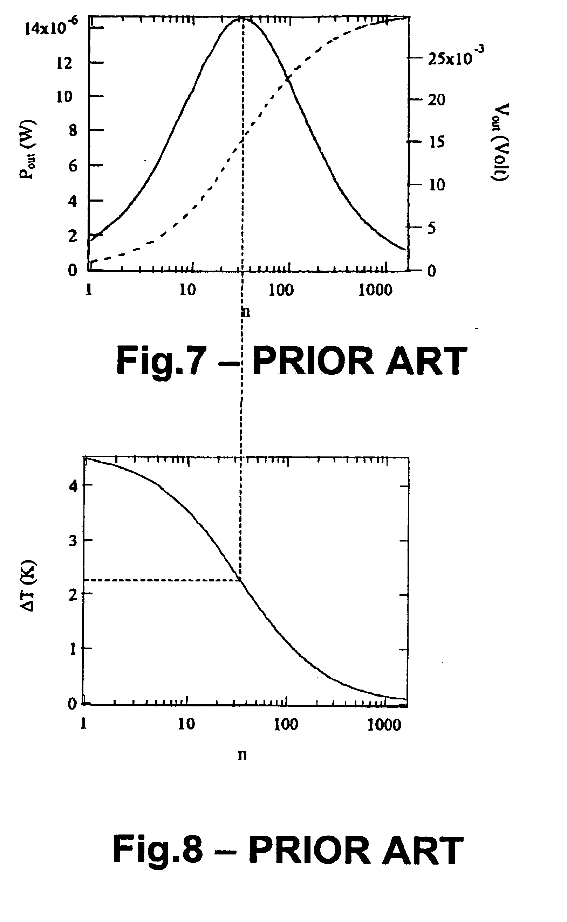

First, a commercial TEG 20 is considered. Dimensions chosen for the legs 11, 12 are close to those of the best commercial devices, i.e. a lateral size $a$ of 0.25 mm, the lateral size $a$ being defined as the square root of the cross-section of the legs, and a height $h$ of 0.75 mm (Fig. 1). In Fig. 7, the output power $P_{out}$ (solid line) and output voltage $V_{out}$ (dashed line) for such a TEG 20 are illustrated as a function of the number of thermocouples 10. In correspondence with the maximum power, the output voltage is low, i.e. 15 mV as can be seen from Fig. 7, which is well below the level necessary for powering standard electronics. Typical voltages needed are 3 to 5 V. It is easy and efficient and known to a person skilled in the art to up-convcrt for example 800 mV to these values, however, it is much more difficult and less efficient to reach these values starting from 300 mV or lower.

As can be seen in Fig. 8, the temperature drop corresponding to the maximum power is about 2.3 K. The performance of the TEG 20 can be improved by increasing the aspect ratio of the legs 11, 12. For example, as described by Seiko (M. Kishi, H. Nemoto, T. Hamao, M. Yamamoto, S. Sudou, M. Mandai and S. Yamamoto in "Micro-Thermoelectric Modules and Their Application to Wristwatches as an Energy Source", Proceedings ICT'99 18th International Conference on Thermoelectrics, p.301-307, 1999), the lateral size $a$ and height h of the legs 11, 12 are respectively 0.08 mm and 0.6 mm. In this case, a 0.4 cm$^2$ TEG (10 units of $2\times2$ mm$^2$ size each arc used in the watch described) gives a voltage of 0.15 V when it delivers a maximum power of about 0.022 mW on a load. Although the state-of-the-art aspect ratio $h/a$ of the thermoelectric legs 11, 12 of 7.5 (= 0.6 mm / 0.08 mm) in the above example represents a current technological limit, the voltage obtained is still of impractical use. It can thus be concluded that the low output voltage is the main restriction to a wide use of standard TEGs 20 operated in a low heat flow mode, which is for example the case with heat sources such as industrial sources of wasted heat or pipelines, walls, machinery or homeotherms.

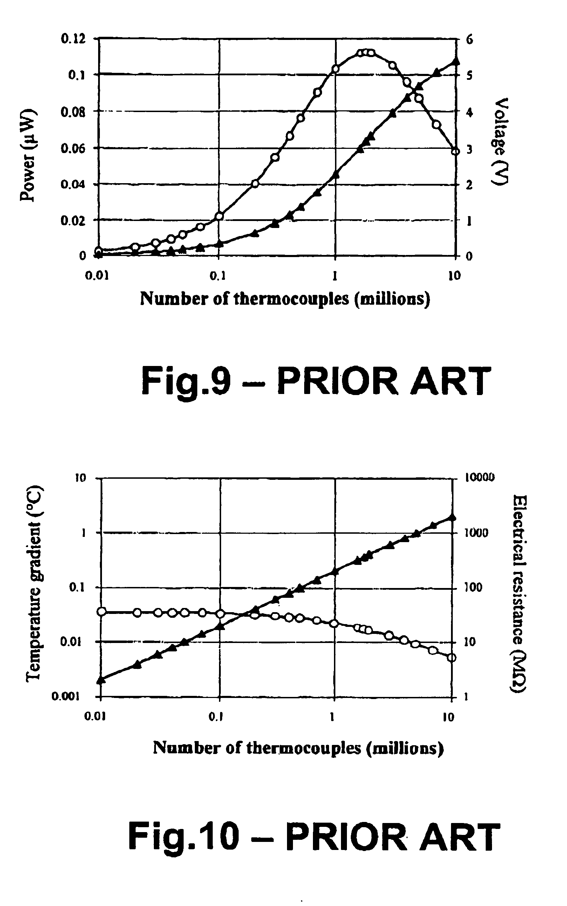

Next, a micromachined TEG 20 is considered which comprises legs with a thickness of 0.5 $\mu$m, a width of 1 $\mu$m and a height of 5 $\mu$m. In Fig. 9, the output power (o) and voltage ($\blacktriangle$) are shown as a function of the number of thermocouples 10. The power is limited to only 0.00011 mW. This maximal power is achieved for a TEG 20 comprising about 1.8 million thermocouples 10 (see Fig. 9). For the same number of thermocouples 10, a voltage of about 3V is obtained. In Fig. 10, the temperature difference (o) between the hot and the cold plates (22, 23) and the electrical resistance ($\blacktriangle$) of a micromachined TEG 20 are reported. The temperature difference (o) between the hot and the cold plates of the TEG 20 at the maximal power is limited to 18 mK. The corresponding thermal resistance, which is determined by $R_{th} = \Delta T/P$ (with $\Delta T$= the temperature difference between the hot and cold plates and P the heat flow) is 1 K/W for a 1 cm$^2$ device, which is not enough to obtain a good temperature drop (e.g. several tens percent of the available temperature difference between the heat source and the heat sink). The above results are confirmed by experimental data. For example, as described by Infineon (M. Strasser, R. Aigner, C. Lauterbach, T. Sturm, M. Franosch and G. Wachutka, "Micromachined CMOS Thermoelectric Generators as On-chip Power Supply", Transducers '03, 12th International Conference on Solid State Sensors, Actuators and Microsystems, p.45-48, 2003), a large number of thermocouples 10 has been fabricated and a large output voltage is obtained. H. Böttner, A. Schubert, K. Schlereth, D. Eberhard, A. Gavrikov, M. Jägle, G. Kühner, C. Kunzel, J. Nurnus and G. Plescher point out in "New Thermoelectric Components using Micro-System-Technologies", ETS 2001 - 6th European Workshop on Thermoelectrics, 2001, that both the temperature drop and the output power are low in micromachined TEGs 20. For example, micromachined TEGs produced by Infineon show about 10 mK temperature difference between the hot and the cold side (H. Böttner in "Thermoelectric Micro Devices: Current State, Recent Developments and future Aspects for Technological Progress and Applications", Proceedings of the 21st International Conference on Thermoelectrics, p.511-518, 2002).

For the number of thermocouples 10 at which the maximum power is achieved (see Fig. 9), the electrical resistance approaches 0.4 G$\Omega$ (see Fig. 10), which is a too high value to be efficient e.g. for a generator powering electronic devices or battery chargers. It can be seen that the optimal number of thermocouples 10 is about 1.8 million, because in that case the thermal resistance of the air between the hot plate 22 and the cold plate 23 of the thermopile 21 is equal to the thermal resistance of the thermoelectric material forming the thermocouples 10, so the output power is maximized. A TEG device with an area of 1 cm$^2$ and with this large number of thermocouples 10 can be fabricated if one thermocouple 10 occupies a square of only about $7\times7$ $\mu$m$^2$ size. This is a difficult but not impossible task. The large number of thermocouples 10 furthermore has the drawback of increased probability of getting a non-functioning device, since thermocouples 10 are electrically coupled in series. Hence, the failure of one thermocouple 10 will cause the failure of the whole TEG 20. This drawback potentially leads to a dramatically decreased yield of good devices and increased cost of manufacturing.

A thermal analysis of the TEG 20 as illustrated in Fig. 2 is performed and analytical results are reported and discussed hereinafter. It is assumed that the hot plate 22 and the cold plat 23 are of equal size. The number of thermocouples $n$, the temperature drop $\Delta T$ and the output voltage $V_{out}$ at a maximal power $P_{out}$ are given by the expressions (1) to (4):

$$n = \frac{G_{air}h}{g_{te}a^2} = \frac{Ag_a}{g_{te}a^2} , \qquad\qquad (1)$$

$$P_{out} = \frac{1}{16}S^2 \frac{W_u^2 A^2}{g_{te}\rho} \frac{1}{G_{air}} = \frac{1}{16}S^2 \frac{W_u^2 A}{g_{te}\rho} \frac{h}{g_a} , \qquad\qquad (2)$$

$$\Delta T = \frac{W_u A}{2 G_{air}} = \frac{W_u h}{2 g_a}, \tag{3}$$

$$V_{out} = \frac{W_u A S}{2 g_{tc}} \frac{h}{a^2}, \tag{4}$$

wherein $A$ is the area of the hot/cold plate 22, 23,
$a$ is the lateral size of the legs 11, 12, being defined as the square root of the cross-section of the legs,
h is the height of the legs 11, 12 (as indicated in Fig. 1),
$g_a$ is the thermal conductivity of air,
$g_{tc}$ is the thermal conductivity of the thermoelectric material the legs 11, 12 are made of,
ρ is the resistivity of the thermoelectric material the legs 11, 12 are made of,
$S$ is the Seebeck coefficient (assumed to be equal for both legs 11, 12),
$G_{air}$ is the thermal conductance of the air between the hot plate 22 and the cold plate 23,
$W_u$ is fixed heat flow per unit area.

Equation (1) and (2) show that, at the maximum power condition the number n of necessary thermocouples and the output voltage depend on the ratio $h/a^2$. It can then be stated that micromachined thermoelectric generators require a larger number of thermocouples and deliver power at a larger voltage than non-micromachined generators. The power $P_{out}$ and temperature difference $\Delta T$ (resp. equation (2) and (3)) depend mainly on the thermal conductance $G_{air}$ of the air between the hot plate and the cold plate. Since this thermal conductance $G_{air}$ is large for micromachined thermopiles, the temperature drop $\Delta T$ and power $P_{out}$ are low for these devices.
The performance of the micromachined TEG according to EP 1 612 870 as illustrated in Figs. 3 to 6 is described by the following formulas:

$$n = \frac{G_{air}}{\left[ \dfrac{g_a b^2 + g_{tc} a^2}{h} \right]} \tag{5}$$

$$P_{out} = \frac{1}{16} S^2 \frac{W_u^2 A^2}{\rho} \frac{1}{G_{air}} \frac{1}{g_{tc} + \dfrac{b^2}{a^2} g_a} \tag{6}$$

$$V = S \frac{WA}{2} \left[ \frac{h}{g_a b^2 + g_{tc} a^2} \right] \tag{7}$$

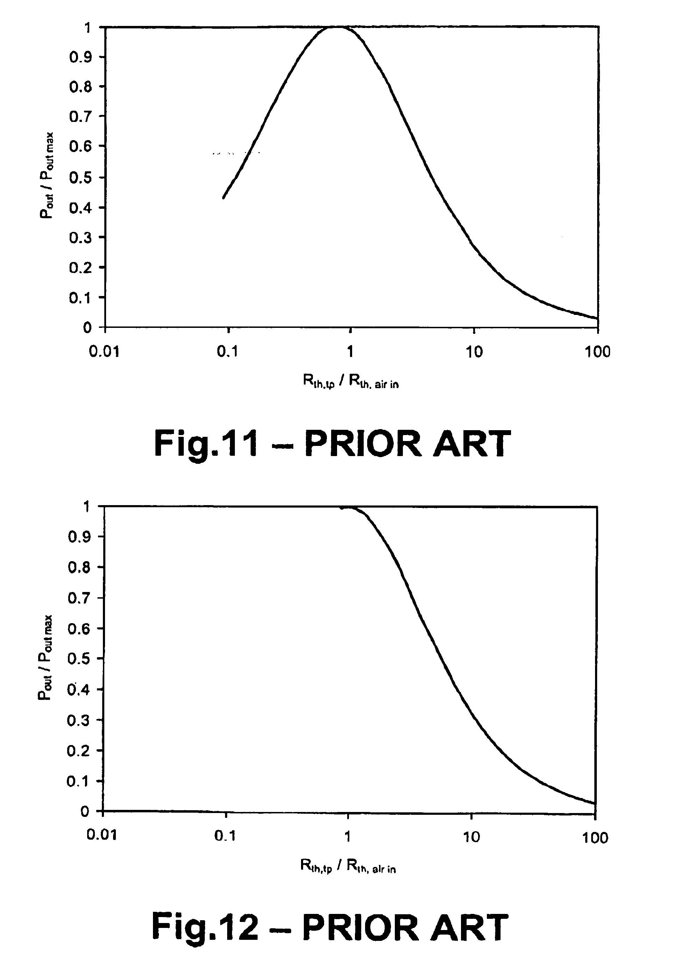

Wherein b is the lateral size of the plates 32, 33 corresponding to a basic element 30, as indicated in Fig. 3.
It has to be noticed that expression (5) for the maximal number of thermocouples 10 and expression (6) for the power are similar to expressions (1) and (2), however, according to EP 1 612 870, $G_{air}$ is small. As a consequence, the number of thermocouples 10 to obtain the maximal power is reduced, while the maximal power is increased. The expression (7) of the voltage is also similar to expression (4), it mainly depends on the dimensions of the thermocouples 10.
As an example, an optimization of a commercial TEG is performed below by modelling of the thermopile having a leg size that is the same as used in a state-of-the-art Seiko thermocouple, i.e. with $h$=0.6 mm and $a$=0.08 mm, Fig. 2, where each leg occupies $0.2 \times 0.2$ mm$^2$ area on the chip. The prior art method of optimizing is in finding a condition of equality of the thermal conductance through the air to the thermal conductance through the thermopile leg material, giving the optimal number of thermocouples corresponding to the maximal power generated. The output power is plotted in Fig. 11 versus the ratio of the thermal resistance of the thermopile leg material to the parasitic thermal resistance of the air (each ratio corresponding to a different number of thermocouples) and is found to obey equations (1)-(4). Calculations are performed for a $1 \times 1$ cm$^2$ chip size, i.e. larger than used in Seiko thermopiles, in order to reach matching conditions, i.e. when the thermal resistance of the thermopile is equal to the thermal resistance of the air in between the two plates. The optimal number of thermocouples 10 is found for the following conditions: the source temperature $T_s$ inside the human body, i.e. the core temperature, is 37 °C, the environmental temperature of ambient air, $T_{amb}$, is 22 °C, the thermal resistance of the body $R_{th}$ = 300 cm$^2$.K/W, the contact area of the device with the skin is 1 cm$^2$, and the distance between the hot and the cold plates is 0.6 mm. The material parameters used for the modelling are reported in Table I.

Optimising a micromachined thermopile is performed next for a TEG 20 using the following dimensions of the legs 11, 12: $h$=0.005 mm and $a$=0.001 mm, where each leg occupies $0.01 \times 0.005$ mm$^2$, Fig. 2. The calculations are performed at $T_5$ = 37 °C, $T_{amb}$ = 22 °C, the thermal resistance of the body $R_{th,source}$ =300 cm$^2$.K/W, contact area of the device with the skin and the two plates are 1 cm$^2$ each, the distance between the hot and the cold plates is 0.005 mm. Results are shown in Fig. 12. The material parameters used for the modelling are reported in Table I hereinabove.

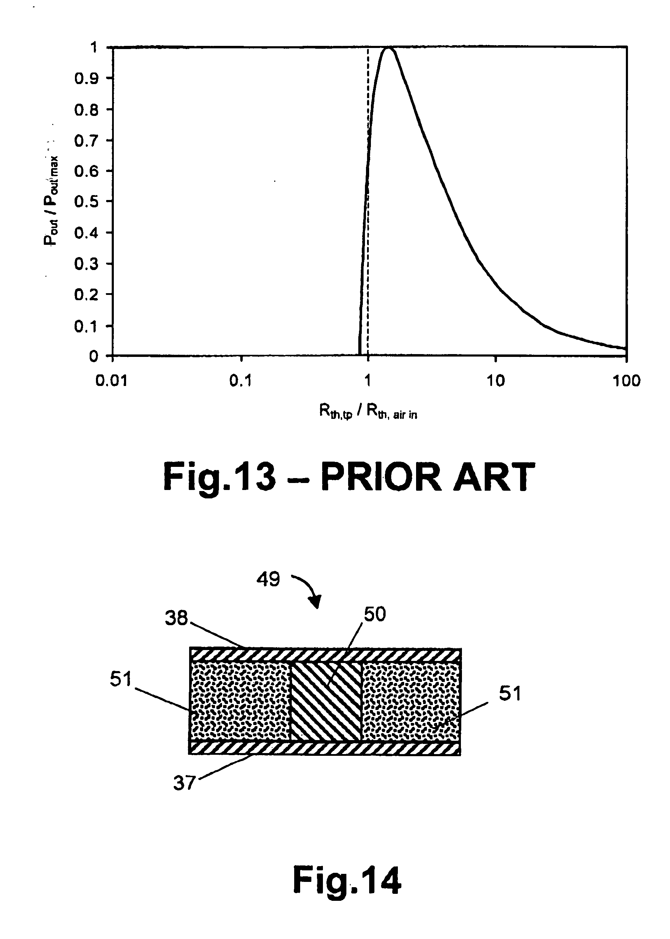

Optimising a micromachined TEG 40 (Figs. 3 to 6) fabricated according to EP 1 612 870 when the thermopiles are being positioned on a spacer 41, is performed next. According to the state of the art, the matching conditions can be found using equations (5)-(7). The optimal number of thermocouples is then considered to occur at the same conditions as in above two examples, i.e. when the thermal conductance through the air in between the hot and cold plates is equal to the thermal conductance through the thermopile leg material. However, when the results are plotted, see Fig. 13, the plot shows a distinct mismatch of the optimal power to the condition of the equality of the thermal conductance through the air to the thermal conductance through the thermopile leg material, and true matching conditions must be found to make the TEG generate the maximal power. It is pointed out that the thermal resistance of the heat source and the heat sink as seen in equations (1)-(7), does not affect the result of the TEG 20 and TEG 40 optimisation according to the prior art.

According to EP 1 612 870, the ratio of thermal resistance $R_{th,tp}$ between the hot and cold junctions of the thermopile to the thermal resistance $R_{th, source-sink}$ between the heat source and the heat sink (hot plate 37 and cold plate 38 as illustrated in Figs. 3 to 6) is an important property of the thermal design of a TEG for application on a heat source with large thermal resistance. This is of lesser importance when the thermopile is used under condition of a constant temperature difference between the hot plate and the cold plate. However, this becomes important in case of constant or limited heat flow especially in case of application of the TEG on a heat source with large thermal resistance when the heat flow is varied depending on the thermal resistance of the thermopile. This ratio is equal to the coefficient of utilization of the temperature difference, $C_T$, occurring between the heat source and the sink. In the above case this coefficient is defined in EP 1 612 870 as:

$$C_T = R_{th,tp} / R_{th,source-sink} = \Delta T_{tp} / \Delta T_{source-sink} = \Delta T_{tp} / (T_s - T_{amb}) \qquad (8)$$

wherein $\Delta T_{tp}$ is the temperature drop over the thermopile, $T_s$ is the source temperature, e.g. a body core temperature in case of a homeotherm as a heat source, $T_{amb}$ is the temperature of ambient air in case it is used as a heat sink or, e.g., a radiant temperature of ambient space if the TEG is used for space applications.

## Summary of the invention

It is an aim of the present invention to provide thermoelectric generators (TEGs), more specifically TEGs operated under conditions of non-constant heat flow and non-constant temperature difference, with good output power. More specifically, the present invention provides a method for thermal matching of such a TEG with its heat source and its heat sink. Furthermore, it is an aim of the present invention to provide a design method for thermal matching of a thermoelectric generator operated under conditions of non-constant heat flow and non-constant temperature difference.

A thermoelectric generator for connection between a heat source and a heat sink according to embodiments of the present invention comprises a thermopile unit, the thermopile unit comprising at least one thermopile stage, each thermopile stage comprising a number of thermocouples each having a couple of thermocouple legs, the thermocouple legs being provided in between a hot junction plane and a cold junction plane. The number of thermocouples in a thermoelectric generator according to embodiments of the present invention is such that the thermal resistance ($R_{TEG}$) of the thermoelectric generator between the hot junction plane comprising the hottest junctions of a thermopile stage and the cold junction plane comprising the coldest junctions of the thermopile stage does not deviate more than 50%, preferably not more than 20%, more preferred not more than 10%, still more preferred not more than 5% from the thermal resistance of the ambient ($R_{th,amb}$), being the sum of the thermal resistance of the heat source, the thermal resistance of the heat sink and the thermal resistance of all parts of the thermoelectric generator serially coupled to the at least one thermopile stage, multiplied by the parasitic thermal resistance ($R_{TEG,0,1}$) between the hot junction plane comprising the hottest junctions of the thermopile stage and the cold junction plane comprising the coldest junctions of the thermopile stage for a same thermoelectric generator but comprising no thermocouples or only one thermocouple leg, this product being divided by the sum of the parasitic thermal resistance ($R_{TEG,0,1}$) between the hot junction plane comprising the hottest junctions of the thermopile stage and the cold junction plane comprising the coldest junctions of the thermopile stage for a same thermoelectric generator but comprising no thermocouples or only one thermocouple leg, summed with twice the thermal resistance of the ambient ($R_{th,0,1,amb}$), for a same thermoelectric generator but comprising no thermocouples or only one thermocouple leg.

According to embodiments of the present invention, at least one of the at least one thermopile stage may comprise a first plate thermally connected to the junctions in the hot junction plane and/or a second plate thermally connected to the junctions in the cold junction plane.

The thermopile unit may be thermally connected to and positioned in between a hot plate for connection to the heat source and a cold plate for connection to the heat sink. According to embodiments of the present invention, the thermoelectric generator may furthermore comprise a radiator mounted on or placed instead of the cold plate.

The surface area of the hot plate may be larger than the area of the thermopile unit, the area of the thermopile unit being determined in a plane parallel to the hot plate, and/or the surface area of the cold plate may be larger than the area of the thermopile unit, the area of the thermopile unit being determined in a plane parallel to the cold plate, so as to obtain a better thermal matching. The area of the thermopile unit may be determined by a perpendicular projection of the thermopile unit onto the hot or cold plate.

The thermoelectric generator according to embodiments of the present invention may further comprise at least one thermally conductive spacer between the at least one thermopile stage and the hot plate and/or the cold plate and/or the radiator and/or between two of the thermopile stages. The presence of the at least one thermally conductive spacer may cause improvement of the Rayleigh number or Reynolds number of the heat transfer at the surface of the cold plate or at the surface of the radiator, as compared with the same thermoelectric generator without said at least one thermally conductive spacer.

In embodiments of the present invention the thermopile unit may comprise more than one thermopile stage, thus improving the Rayleigh number or Reynolds number of the heat transfer at the surface of the cold plate or at the surface of the radiator as compared with the same thermoelectric generator comprising a thermopile unit with one thermopile stage.

According to embodiments of the present invention, the thermoelectric generator may furthermore comprise at least one heat-spreading chip between the at least one thermopile stage and the hot plate and/or the cold plate and/or between two of said at least one thermopile stages. A radiator may be mounted on or placed instead of the cold plate.

The thermoelectric generator according to embodiments of the present invention may furthermore comprise a shock-protecting structure. The shock-protecting structure may for example comprise a thermally isolating plate with pillars from thermally isolating material connected to the cold plate. The thermoelectric generator according to embodiments of the present invention may furthermore comprise a touch-protecting structure.

The thermoelectric generator according to embodiments of the present invention may furthermore comprise a thermal reflector positioned in between the hot plate and the cold plate, the thermal reflector covering the hot plate, the cold plate, the radiator, the first plate and/or the second plate and being thermally isolated therefrom.

The thermoelectric generator according to embodiments of the present invention may be attached to a wrist strap, a head strap, a strap for animals or may be embedded into clothes and garments, a cap, a shoe, a belt, jewellery or a clamp for attaching to such objects. The thermoelectric generator may be supplied with additional heat transfer means mounted in a piece of clothing for being worn above or under garment in which said thermoelectric generator is embedded or attached. These heat transfer means may include heat-conductive threads or wires into the piece of clothing. The thermal interconnection of the thermoelectric generator and the heat transfer means may be performed magnetically using magnets and corresponding metal pieces in different layers of clothing.

In embodiments of the present invention, the thermocouples may be micromachined thermocouples.

The thermocouples may be positioned on a polymer tape or on a membrane, or thin/thick-film thermocouples without a substrate may be used.

At least one of the at least one thermopile stage may comprise a thermally conductive structure forming a thermal interconnection between the thennocouple legs and at least one of the cold plate, the hot plate, and the radiator, said thermally conductive structure comprising a thin/thick film of thermally conductive material or a substrate material.

In embodiments of the present invention, the thermoelectric generator may be filled at least partially with thermally isolating material. This thermally isolating material may for example be a micro- or sub-microporous material having a thermal conductivity less than the thermal conductivity of air or not exceeding the thermal conductivity of air by 50%.

The inner volume of the thermoelectric generator according to embodiments of the present invention may be encapsulated on its perimeter between the hot plate and the cold plate or the radiator, using a layer of thermally isolating material. This layer of thermally isolating material may also serve as a shock-protecting structure.

The volume between the hot plate and the cold plate or the radiator may be filled with a gas having lower thermal conductivity than air or which is at a pressure that is lower than the atmospheric pressure.

In embodiments according to the present invention, the inner surface of the hot plate or the inner surface of the reflector (the inner surface being the surface not facing the heat source) may have a low emissivity (lower than 20%, preferably lower than 10%) in the infrared region and the inner surface of the cold plate and the radiator (the inner surface being the surface not facing the heat sink) may have a high emissivity (higher than 90%, preferably higher than 95%) in the infrared region.

The present invention is furthermore related to a method for designing a thermoelectric generator for connection between a heat source and a heat sink and with a limited heat flow through the thermoelectric generator and a non-constant temperature difference between the heat source and the heat sink, the thermoelectric generator comprising a thermopile unit, said thermopile unit comprising at least one thermopile stage, each thermopile stage comprising a number of thermocouples each having a couple of thermocouple legs, the thermocouple legs being provided in between a hot junction plane and a cold junction plane. The design method comprises: determining the thermal resistance ($R_{TEG}$) of the thermoelectric generator between the hot junction plane comprising the hottest junctions of the thermopile stage and the cold junction plane comprising the coldest junctions of the thermopile stage as a function of the number of thernmocouples; determining the sum ($R_{th,amb}$) of the thermal resistance of the heat source, the thermal resistance of the heat sink and the thermal resistance of all parts of the thermoelectric generator serially coupled to the at least one thermopile stage, as a function of the number of thermocouples; determining the parasitic thermal resistance ($R_{TEG,0,1}$) between the hot junction plane comprising the hottest junctions of the thermopile stage and the cold junction plane comprising the coldest junctions of the thermopile stage for a same thermoelectric generator but comprising no thermocouples or only one thermocouple leg; determining the sum ($R_{th,0,1,amb}$) of the thermal resistance of the heat source, the thermal resistance of the heat sink and the thermal resistance of all parts of the thermoelectric generator serially coupled to the at least one thermopile stage, for a same thermoelectric generator but comprising no thermocouples or only one thermocouple leg; dividing the product of $R_{th,amb}$ and $R_{TEG,0,1}$ by the sum of $R_{TEG,0,1}$ and twice $R_{th,0,1,amb}$, resulting in a thermal resistance value; and adapting the number of thermocouples such that the thermal resistance ($R_{TEG}$) of the thermoelectric generator between the hot junction plane comprising the hottest junctions of the thermopile stage and the cold junction plane comprising the coldest junctions of the thermopile stage does not deviate more than 50%, preferably not more than 20%, more preferred not more than 10%, still more preferred not more than 5% from said thermal resistance value.

The term "limited heat flow" means that when decreasing the thermal resistance of the TEG, the heat flow through the device increases till a certain value, at which the conditions of constant heat flow are reached. In the case of "limited heat flow" the heat flow through the device is not limited by the ambient, but for example by the thermal resistance of the TEG or by the thermal resistance of the heat sink.

Embodiments of the method for designing a thermoelectric generator may furthermore comprise varying the shape and/or the size of a hot plate and/or a cold plate and/or a radiator, whereby the thermopile unit is thermally connected to and positioned in between the hot plate for connection to the heat source and the cold plate for connection to the heat sink The method for designing a thermoelectric generator according to embodiments of the present invention may furthermore comprise providing at least one thermally conductive spacer in between the at least one thermopile stage and the hot plate and/or the cold plate and/or the radiator and/or between two of the thermopile stages. The at least one thermally conductive spacer may improve the Rayleigh number or Reynolds number of the heat transfer at the surface of the cold plate or at the surface of the radiator as compared with the same thermoelectric generator without said at least one thermally conductive spacer.

The method for designing a thermoelectric generator may furthermore comprise providing a radiator mounted on or placed instead of the cold plate, and varying the size and/or the shape of the radiator.

The thermocouples may be positioned on a polymer tape or on a membrane, or thin/thick-film thermocouples without a substrate may be used.

Furthermore, the present invention provides a computer program product for executing a method for designing a thermoelectric generator according to embodiments of the present invention. The present invention also provides a machine readable data storage device storing the computer program product in accordance with embodiments of the present invention. The present invention also provides transmission of the computer program product in accordance with embodiments of the present invention over a local or wide area telecommunications network.

The thermoelectric generator according to embodiments of the present invention may be used with an animal, a human being, a clothed human being or ambient air as a heat source and with ambient air, an animal, a human being or a clothed human being as a heat sink.

The thermoelectric generator according to embodiments of the present invention may be used with a space object or an artificial space object as a heat source and interplanetary space, a space object or an artificial space object as a heat sink.

The thermoelectric generator may be used with a distant radiating object or a plurality of distant radiating objects like space objects or ambient objects as a heat source and Earth surface as a heat sink.

These and other characteristics, features and advantages of the present invention will become apparent from the following detailed description, taken in conjunction with the accompanying drawings, which illustrate, by way of example, the principles of the invention. This description is given for the sake of example only, without limiting the scope of the invention. The reference figures quoted below refer to the attached drawings.

**Brief description of the drawings**

Fig. 1 is a schematic illustration of a thermocouple comprising an n-type and a p-type semiconducting leg and conductive interconnects, e.g. metal layer interconnects.

Fig. 2 is a schematic illustration of a simple prior art TEG comprising a (large) number of thermocouples sandwiched in between a hot plate and a cold plate; the example illustrated only shows 6 thermocouples, but the TEG may comprise many more.

Fig. 3.a is a schematic illustration of a basic element according to EP 1 612 870 forming a thermopile chip; Fig. 3.b is a schematic illustration of a thermopile chip according to EP 1 612 870, sandwiched between two plates.

Fig. 4 is a side view of an assembly of a micromachined thermopile chip and a micromachined heat-spreading chip with two plates and a spacer, according to EP 1 612 870.

Fig. 5 is another side view of an assembly of a micromachined thermopile chip and a micromachined heat-spreading chip with a spacer and a radiator according to EP 1 612 870.

Fig. 6 is a cross-sectional view of an assembly of a micromachined thermopile chip and a micromachined heat-spreading chip with a spacer and a radiator according to EP 1 612 870.

Fig. 7 shows voltage (---) and electrical power (-) as a function of the number of thermocouples for a commercially available BiTe TEG as illustrated in Fig. 2.

Fig. 8 shows temperature difference between the hot and the sides as a function of the number of thermocouples for a classical BiTe TEG as illustrated in Fig. 2.

Fig. 9 shows voltage (▲) and electrical power (o) as a function of the number of thermocouples for a prior art micromachined BiTe TEG.

Fig. 10 shows temperature difference (o) between the hot and cold plates and the corresponding electrical resistance (▲) of a prior art micromachined BiTe TEG, as a function of the number of thermopiles.

Fig. 11 shows calculation results for the thermal matching of a commercially available prior art thermopile.

Fig. 12 shows calculation results for the thermal matching of a prior art micromachined thermopile.

Fig. 13 shows calculation results for the thermal matching of a micromachined thermopile fabricated on raised elongate structure according to EP 1 612 870.

Fig. 14 shows an embodiment of the TEG according to the present invention.

Fig. 15 shows a thermopile unit of the TEG according to embodiments of the present invention.

Fig. 16 shows a TEG with multi-stage thermopiles according to embodiments of the present invention.

Fig. 17 shows another TEG with multi-stage thermopiles and thermal isolation according to embodiments of the present invention.

Fig. 18 shows a TEG in accordance with embodiments of the present invention on a human wrist and explains the effect of decoupling the Rayleigh/Reynolds numbers.

Fig. 19 shows a TEG with multi-stage thermopiles in accordance with embodiments of the present invention on a human wrist and explains the effect of decoupling the Rayleigh/Reynolds numbers.

Fig. 20 shows the dependency of the power on the ratio of the thermal resistance of the thermopile because of thermal conductance through the thermocouple legs to the thermal resistance of the air in between the cold and hot plates, in accordance with embodiments of the present invention.

Fig. 21 shows the dependency of the power and changes in the heat flow due to the presence of the TEG on the ratio of the temperature drop on the thermopile and the temperature drop occurring in the same TEG without the thermopile or with only one thermocouple leg of the same size in it, in accordance with embodiments of the present invention.

Fig. 22 shows a TEG on a human arm with a thermal isolation sheet added to the garment, in accordance with embodiments of the present invention.

Fig. 23 shows a waterproof watch-size wrist TEG with a cold plate and a protecting grid for outdoor use, in accordance with embodiments of the present invention.

Fig. 24 shows a watch-size wrist TEG with a pin-fcatured radiator and a protecting grid for indoor use, in accordance with embodiments of the present invention.

Fig. 25 shows open circuit voltages measured on a TEG in accordance with embodiments of the present invention.

Fig. 26 shows measurement results of the power transmitted into a matched load by a TEG in accordance with embodiments of the present invention.

Fig. 27 shows the difference of power matching (solid line) according to the prior-art approach (o) and the matching according to embodiments of the present invention (▲). The corresponding change of the heat flow is shown for the case of one-stage and multi-stage arrangement of the thermopiles (dotted and dashed lines, respectively). The horizontal arrows show the range of the power for a mismatched 10-stage TEG, where the power still exceeds the power obtainable using the prior art approach.

Fig. 28 shows power produced by a TEG in accordance with embodiments of the present invention, for different numbers of the stages versus the number of thermocouples per stage.

Fig. 29 shows the difference in required number of thermocouples versus number of stages for a matched TEG in accordance with embodiments of the present invention (solid line), compared to a matched TEG in accordance with the prior art approach (dashed line).

Fig. 30 shows the ratio of the thermal resistance of the thermopile due to conductivity through the thermopile legs to the serial resistance composed mainly of the thermal resistance of the heat source and the heat sink (solid line), and the ratio of the thermal resistance of the thermopile to the parallel parasitic thermal resistance of the air in between the cold and hot plates (dashed line) as a function of the number of thermocouples per stage. The matching point according to embodiments of the present invention is marked with (▲), the prior art approach is marked with (o).

Fig. 31 shows the ratio of the thermal resistance of the TEG to the serial resistance composed mainly of the thermal resistance of the heat source and the heat sink as a function of the number of thermocouples per stage. The matching point according to embodiments of the present invention is marked with (▲), the prior art approach is marked with (o).

Fig. 32 shows a TEG with thermopiles fabricated according to EP 1 612 870, with a multi-stage arrangement of the thermopile unit (three stages are shown) in accordance with embodiments of the present invention.

Fig. 33 shows the power for a different number of thermopile stages if using the micromachined thermopiles fabricated according to EP 1 612 870. The matching point according to embodiments of the present invention is marked with (▲), the prior art approach is marked with (O) .

Fig. 34 shows an increase of electrical power due to better thermal matching as proposed in the present invention as compared with the prior art approach.

Fig. 35 shows an increase of electrical power due to the multi-stage arrangement of the thermopile unit proposed in the present invention as compared with the prior art approach.

Fig. 36 shows the sum of two effects separately manifesting themselves in Figs. 33, 34 on power, i.e. the joint effect of better matching and the multi-stage arrangement of the thermopile unit as proposed in the present invention.

Fig. 37 shows the electrical power produced by a TEG matched using a method of embodiments of the present invention (solid line) compared to the power produced when using the prior art approach (dashed line), plotted versus number of stages.

Fig. 38 shows the electrical power produced by a TEG matched using a method of embodiments of the present invention (solid line) compared to the power produced when using the prior art approach (dashed line) plotted versus number of thermocouples in the TEG.

Fig. 39 shows ratio of the voltage of a thermopile matched according to embodiments of the present invention to the voltage of the thermopile matched using prior art approach, as a function of the number of stages.

Fig. 40 shows a TEG with radiation shield (reflector) in accordance with embodiments of the present invention.

Fig. 41 shows a TEG incorporated into clothes, in accordance with embodiments of the present invention.

Fig. 42 shows a TEG fabricated as a "button" implemented into a garment, in accordance with embodiments of the present invention. A case where three garments are worn on top of each other is shown, with heat transferring buttons in the layers covering the inner one with a TEG in accordance with embodiments of the present invention.

In the different figures, the same reference signs refer to the same or analogous elements.

**Description of illustrative embodiments**

The present invention will be described with respect to particular embodiments and with reference to certain drawings but the invention is not limited thereto but only by the claims. The drawings described are only schematic and are non-limiting. In the drawings, the size of some of the elements may be exaggerated and not drawn on scale for illustrative purposes. The dimensions and the relative dimensions do not necessarily correspond to actual reductions to practice of the invention.

Furthermore, the terms first, second, third and the like in the description and in the claims, are used for distinguishing between similar elements and not necessarily for describing a sequential or chronological order. It is to be understood that the terms so used are interchangeable under appropriate circumstances and that the embodiments of the invention described herein are capable of operation in other sequences than described or illustrated herein.

It is to be noticed that the term "comprising", used in the claims, should not be interpreted as being restricted to the means listed thereafter; it does not exclude other elements or steps. Thus, the scope of the expression "a device comprising means A and B" should not be limited to devices consisting only of components A and B. It means that with respect to the present invention, the only relevant components of the device are A and B.

The TEG 49 as illustrated in Fig. 14, according to an embodiment of the present invention, comprises a thermopile unit 50, comprising a thermopile 21 which in its simplest shape is formed by a certain, pre-determined, number of thermocouples 10 electrically connected in series, and placed in between plates 37, 38. The thermopile unit 50 may further comprise other elements which will be explained below. A thermal isolation 51 is present at one or more sides of the thermopile unit 50, and may be formed by vacuum, air or another insulating material, and may include pillars and/or encapsulating structures. The condition for obtaining thermal matching in the case of limited heat flow, in accordance with the present invention, is given by

$$R_{TEG} = R_{th, amb} R_{TEG, 0, 1} / (2 R_{th, 0, 1, amb} + R_{TEG, 1}), \tag{8}$$

where $R_{TEG}$ is the required thermal resistance of the thermoelectric generator between the hot junction plane 24 and the cold junction plane 25 of the thermopile (in case of a multi-stage thermopile, between the coldest and hottest junctions), $R_{th, amb}$ is the thermal resistance of the heat source and the heat sink serial to the thennopile, additionally including the comparatively small thermal resistance of the parts of the thermoelectric generator serially coupled to the thermopile 21, which for a well-matched thermopile can be neglected,

$R_{TEG, 0, 1}$ is the thermal resistance of the thermoelectric generator of exactly the same design, between the hot junction plane 24 and the cold junction plane 25, in which there are no thermocouples, or in which only one thermocouple leg is present,

$R_{th, 0, 1, amb}$ is the thermal resistance of the heat source and the heat sink serially coupled to the thermopile additionally including the comparatively small thermal resistance of the parts of the thermoelectric generator serially coupled to the thermopile 21, under condition that there are no thermocouples, or that only one thermocouple leg is present.

Based on this condition, the optimum number of thermocouples may be determined. It can easily be shown that the condition of thermal matching (8) corresponds to the condition that the temperature drop over the thermopile 21 between the hot junction plane 24 and the cold junction plane 25 is equal to half of the temperature drop obtainable in a same embodiment at equal other relevant conditions, but when there are no thermocouple legs in between plates 37, 38, or there is only 1 thermocouple leg 11 or 12. It is to be noted that this condition is neither the same as in case one gets over the thermopile half of the available temperature difference between the heat source and the heat sink, $\Delta T_{source-sink}$ nor the same as in case there is equality of the thermal resistance of the thermopile legs or thermopile unit 50 with respect to the thermal resistance of the thermal isolation 51, which is targeted in prior art TEGs for an ambient having high thermal resistance. The thermal matching condition (8) is valid for a condition of limited heat flow. Under condition of limited heat flow, the thermal resistance of the TEG is of the same order of magnitude as the thermal resistance of the ambient. The heat flow is then significantly different between two cases: heat flow in a TEG with the number of thermocouple legs calculated in accordance with embodiments of the present invention and heat flow in a corresponding TEG with no or with only one thermocouple leg. If only a small difference (e.g. a few percent) in heat flow is observed between the two cases (e.g. between a prior art TEG and a corresponding TEG with no or with only one thermocouple leg), this means that the TEG is not suited for applications with limited heat flow as in embodiments of the present invention.

The performance of a TEG 49 as described in the above embodiment may be enhanced in several ways, e.g.

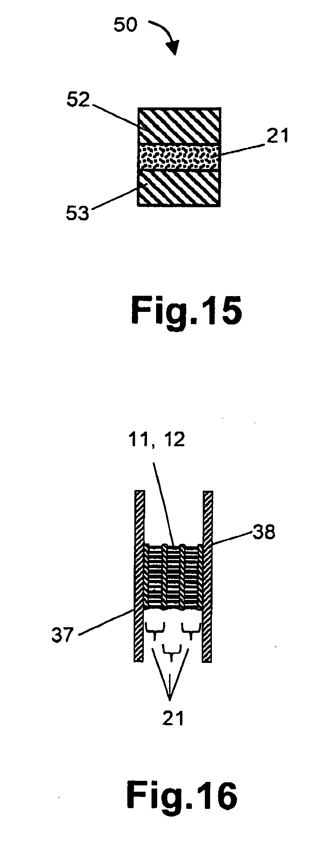

(i) by adding at least one thermally conducting spacer 52, or 53, or two spacers 52, 53 into the thermopile unit 50, thus separating the thermopile 21, comprising a plurality of thermocouples coupled in parallel thermally and in series electrically, from at least one of the hot and/or the cold plates 37, 38, as illustrated in Fig. 15, and/or

(ii) by varying the contact area of the TEG 49 with the heat source and the heat sink, i.e. changing the dimensions of the hot and/or cold plates 37, 38, and/or

(iii) by appropriately choosing materials and design in order to obtain the required thermal isolation between the hot plate 37 and the cold plate 38.

Hereinafter, these possibilities to enhance the performance of the TEG 49 according to embodiments of the present invention will be discussed for a TEG 49 attached to a wrist or to a forehead of a person. However, this is only by means of an example and is not intended to be limiting for the invention, which is applicable for all ambient heat sources and heat sinks with high thermal resistance (e.g. between 10 cm$^2$.K/W and 1000 cm$^2$ K/W), like, e.g. homeotherms, i.e. in case of limited heat flow.

At usual ambient temperatures, i.e. typically between 15 and 25 °C, e.g. 20°C, the thermal resistance of the human body $R_{th,body}$ ranges from about 100 cm$^2$.K/W to about 1000 cm$^2$.K/W with the possibility to be out of the mentioned range; the same holds for the thermal resistance of ambient air. Therefore, by increasing the contact area between the hot and cold plates 37, 38 and the ambient, i.e. by changing dimensions and/or shape of the hot and/or cold plates 37, 38, the heat flow from the body to the ambient can be enhanced. Increasing the contact area between the cold plate 38 and air may be done by e.g. adding a radiator 48 to the cold plate 38 or by shaping the cold plate as a radiator 48 with developed surface like fins or pins (i.e. changing the shape and dimensions of the cold plate 38). The different shapes of the plates 37, 38, and of the radiator 48 also may offer significant improvement of the generated power. As an example, the human wrist has non-uniform temperature on its circumference, and a hot plate of $2 \times 2$ cm$^2$ placed on radial or ulnar artery according to EP 1 612 870, provides better heat flow than prior art devices placed on the outer side of the wrist. However, reshaping this area into $1 \times 4$ cm$^2$ and placing it aligned with the artery produces a better heat flow on the same area, or better heat flow per square centimetre of the skin, resulting in better generated power.

The performance of the TEG 49, according to other embodiments of the present invention, may be improved thus generating more power at equal ambient conditions (e.g. same air temperature, air speed, absorbed radiation, thermal resistance of heat source and heat sink, , if at least one spacer 52, 53 is used, irrespective of any particular type of thermopiles used, i.e, commercial ones, on a polymer tape, micromachined thermopiles, or thick/thin thermopiles on a membrane. Unlike the spacers in micromachined thermopiles fabricated according to EP 1 612 870, which height must be at least 10 times larger than the height of thermopile 21, the proposed spacer 52, 53 in accordance with embodiments of the present invention is to move the cold plate 38 or the radiator 48 out of the air jet of free convection occurring around the heat source, e.g. human body. The conditions when the thickness of the buoyancy-driven free boundary layer is thin enough to obtain a significant percentage of temperature drop at a distance from the hot plate (37) corresponding to the location of the cold plate (38) or the radiator (48) can be found. As an example, the temperature rise in the air around a horizontally positioned wrist decreases to 20% of the temperature difference between the air and the skin at about 7 mm from the skin. Therefore, by introducing at least one spacer 52, 53 to make the distance in between the hot and cold plates 37, 38 equal to or more than 7 mm, the cold plate 38 is thereby moved into the cold air. This causes decoupling of the Rayleigh number of the heat transfer at the surface of the cold plate (38) or at the surface of the radiator (48) from the heat transfer on a wrist and results in an increase of the heat transfer as compared with the TEG 49 without the at least one spacer 52, 53. The same effect is observed for the forced convection, when the Reynolds number of the heat transfer at the surface of the cold plate (38) or at the surface of the radiator (48) is improved and the required pillar is smaller in this case because the boundary layer is thinner in case of forced convection. As an example, a standing animal is at free convection conditions, while a walking animal is at forced convection conditions.

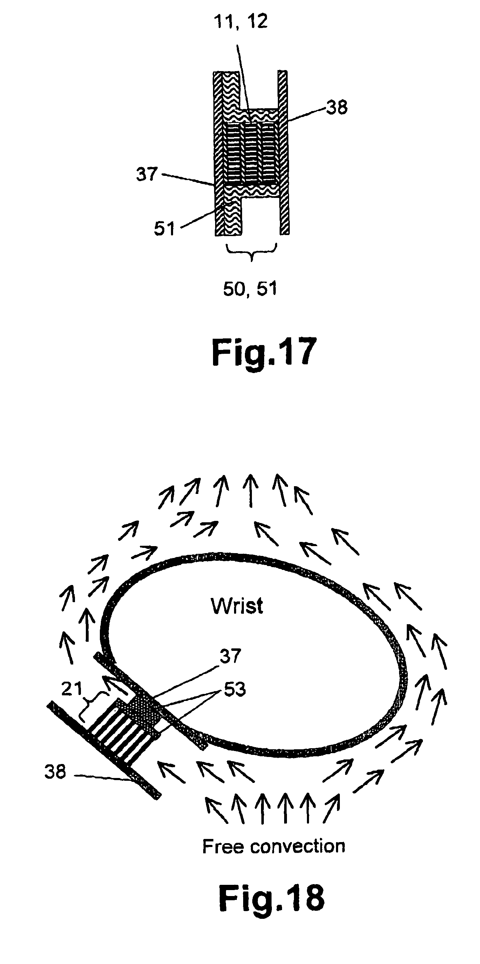

The at least one spacer 52, 53 as discussed above is not necessary if the thermopile 21 is made with corresponding increase of its thickness, the thickness being defined as the average distance in between the hot junction plane 24 and the cold junction plane 25 in the direction of average heat flow, without deterioration of its properties. Therefore, if commercially available thermopiles are used to build the thermopile unit 50 in accordance with embodiments of the present invention, these are preferably arranged into a multi-stage structure like the one shown in Figs. 16, 17 so that the thermogenerator obeys the matching conditions (8) according to the present invention. In Fig. 16 a 3-stage thermoelectric generator 49 according to embodiments of the present invention is shown, comprising 3 stacked thermopiles (21) or thermopile stages. Stacking of thermopiles 21 results in an increased thickness of the thermoelectric generator 49, thus moving the cold plate 38 or the radiator 48 out of the air jet of free or forced convection around the heat source, and improving the Rayleigh or Reynolds number of the heat transfer at the surface of the cold plate (38) or at the surface of the radiator (48), resulting in an increase in power output. Fig. 17 shows a 3-stage thermoelectric generator 49 with thermal isolation 51 (e.g. a nano-porous material), for decreasing the parasitic heat transfer from the hot plate 37 and the thermopile unit 50 to the air.

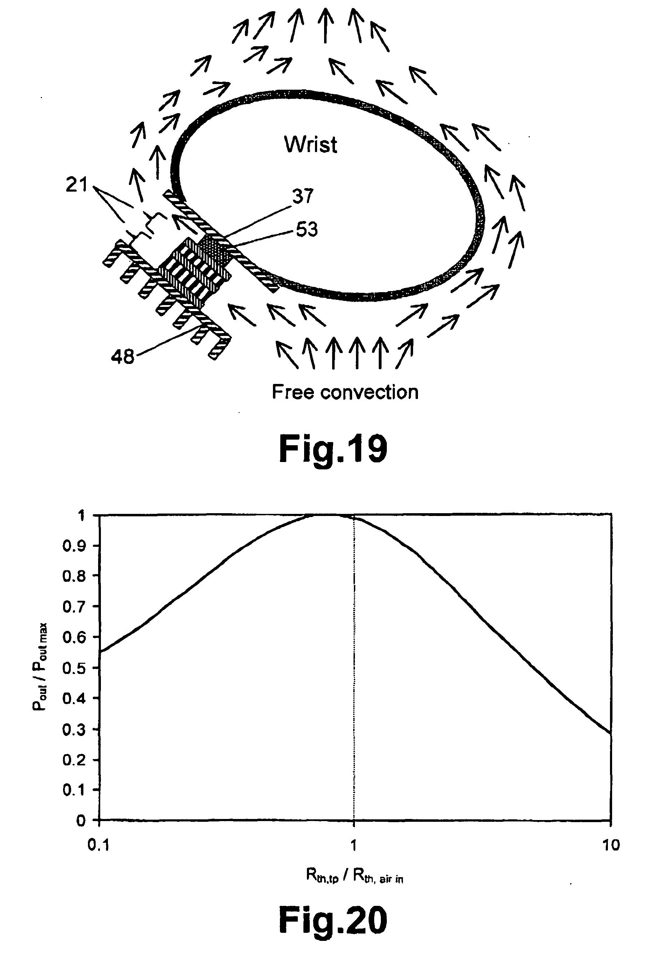

Similar to the one-stage thermoelectric generator, the multi-stage thermoelectric generator in accordance with embodiments of the present invention may further contain at least one spacer 52, 53 to further improve the Rayleigh/Reynolds number of the heat transfer at the surface of the cold plate (38) or at the surface of the radiator (48), thereby increasing the power production on cost of increased thickness of the TEG, Fig. 18, 19.

In case commercially available thermopiles or other non-micromachined thermopiles are used in a TEG 49 in accordance with embodiments of the present invention, the minimal voltage requirement may dominate over the requirement of maximal power. The overall outer TEG size and its total thickness are also frequently limiting boundary conditions for practical applications of the TEGs . In all these cases, the thermal mismatching of the TEG, i.e. a certain deviation from the optimal power obtained according to the present invention, is acceptable to make the TEG output voltage acceptable for the accompanying electronics. The output power is a weak function of the number of thermocouples near the maximum output power, which corresponds to the condition of thermal matching as given in (8), i.e. the condition where the number of thermocouples is such that the temperature difference over the thermopile 21 between the hot junction plane 24 and the cold junction plane 25 (which depends on the number of thermocouples) is equal to half of the temperature difference obtainable in the same embodiment with no thermocouples in it or with only one thermocouple leg in it. In the case of a multi-stage thermopile unit, the temperature difference over the thermopile 21 is to be understood as the temperature difference over the multi-stage arrangement, between the hot junction plane 24 comprising the hottest junctions (closest to the hot plate 37) and the cold junction plane 25 comprising the coldest junctions (closest to the cold plate 38 or radiator 48).

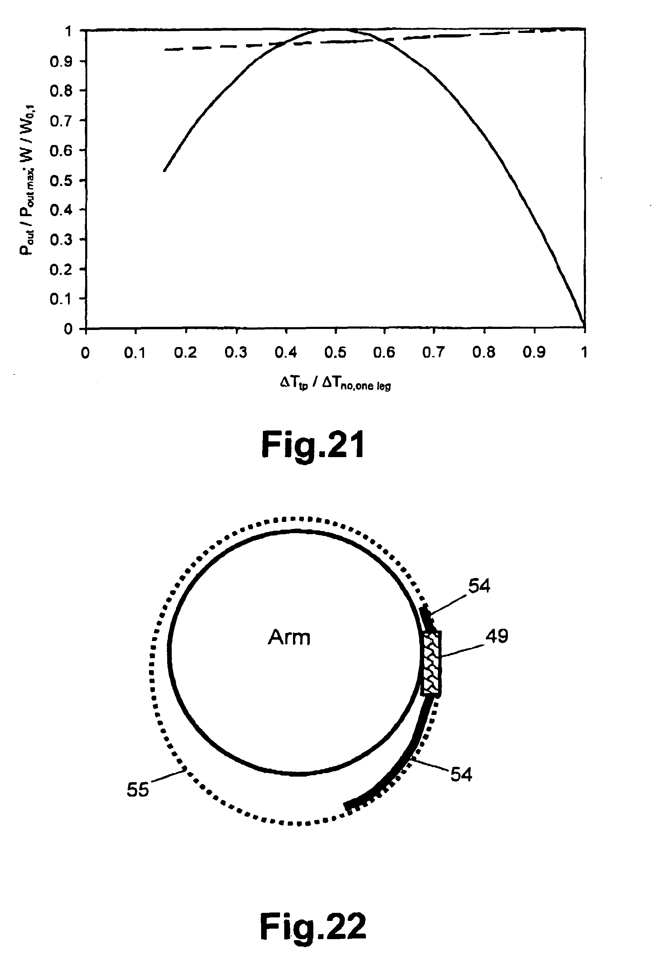

The fact that the dependence of power on obeying the condition of thermal matching (8) is a weak function of the number of thermocouples near the maximum is a property of all matching curves. Therefore, some mismatch from the exact matching requirement in accordance with embodiments of the present invention still allows obtaining better power output conditions in the case of limited heat flow than with corresponding prior art TEGs (i.e. with the number of thermocouples calculated according to another matching condition, e.g. the prior art matching condition wherein the temperature difference over the thermopile unit (50) is equal to half of the temperature difference between the heat source and the heat sink.) To understand the range of the mismatch where the invention allows outperforming prior art TEGs, the heat flow obtainable in prior art and one of the embodiments of the TEG in accordance with the present invention are evaluated and compared. The micromachined thermopiles as described by Infineon (M. Strasser, R. Aigner, C. Lauterbach, T.F. Sturm, M. Franosch and G. Wachutka in "Micromachined CMOS Thermoelectric Generators as On-chip Power Supply", Transducers '03. 12th International Conference on Solid State Sensors, Actuators and Microsystems, p.45-48, 2003) do not show a change in the heat flow through the TEG if the 1 $cm^2$ area of the plates is completely filled with thermocouples as compared with the heat flow through the same device with only 1 thermocouple leg or no thermocouples. The modelling of even better micromachined devices like the one used for calculation of Fig. 12, gives less than 1% variation of the heat flow. For the best-suited thermopiles for human body applications fabricated in the past at Seiko (M. Kishi, H. Nemoto, T. Hamao, M. Yamamoto, S. Sudou, M. Mandai and S. Yamamoto in "Micro-Thermoelectric Modules and Their Application to Wristwatches as an Energy Source", Proceedings ICT'99 18th Int. Conference on Thermoelectrics, p. 301-307, 1999), at 1 $cm^2$ area of the plates, 22 °C ambient temperature and $R_{th,body}$ of 440 $cm^2$.K/W which is observed on the human body where the watch comprising the TEG is worn, calculations show that the decrease of the heat flow if there would be no thermocouples, reaches only about 4%. Contrary thereto, the matching conditions of embodiments of the present invention provide as a side effect a variation of the heat flow through an optimized thermopile unit by at least several tens of percent as compared to the same thermopile design with only 1 thermocouple leg or no thermocouples (numerical example is calculated below.). Moreover, the possibility of mismatching (which has an adverse effect on the TEG power) is being considered usually only if the voltage is not high enough for effectively using the generated power, so that the corresponding number of thermocouples and the related heat flow must be further increased to obtain the required output voltage. Therefore, it may be concluded that mismatched TEGs in accordance with embodiments of the present invention outperform prior art TEGs if the heat flow increases by e.g. more than 5% in the TEG as compared with the same TEG with no thermocouples in it or with only 1 thermocouple leg remaining. The thermal matching curve is shown in Fig. 20 for the above example (Seiko). As one can see, a small but distinct misalignment between the $R_{th,tp}$ / $R_{th,\ air\ in}$ corresponding to the maximum in the output power and the unity of $R_{th,tp}$ / $R_{th,\ air\ in}$ is observed. This small value of the misalignment is caused by the fact that a condition of the thermal matching in accordance with embodiments of the present invention, i.e., a significant variation of the heat flow, should be observed. For the case of matching conditions in accordance with embodiments of the present invention, Fig. 20 is re-plotted in Fig. 21 versus $\Delta T_{tp}$ $\Delta T_{no.one\ leg}$ (solid line) together with the change of the heat flow (dashed line). The maximal power is reached at $\Delta T_{tp}$ / $\Delta T_{no,\ one\ leg}$ = 0.5. The mismatching means making $\Delta T_{tp}$ / $\Delta T_{no,\ one\ leg}$ < 0.5 or $\Delta T_{tp}$ / $\Delta T_{no,\ one\ leg}$ > 0.5.

In examples of TEGs in accordance with embodiments of the present invention which obey the thermal matching conditions in accordance with embodiments of the present invention, as shown in Figs. 16 to 19, any suitable thermopile types may be used, e.g. thermopiles on polymer substrate, micromachined thermopiles or membrane-type thermopiles.

One or more effective rigid or flexible thermal isolation sheets 54 may furthermore be introduced to a garment 55 of homeotherms, e.g. human beings, as depicted in Fig. 22 as an example only, where the example on an arm is shown, while the garment 55 is shown as a dotted line. The thermal isolation sheets 54 thermally isolate the cold plate of the TEG 49 from the heat source and from the air jet of free or forced convection. The garment 55 itself can also serve as a thermal barrier. Such garment or isolation sheets may create larger thermal gradient per centimetre distance from the skin than occurs in the convective boundary layer. In this case, the total thickness of the TEG 49 required for reaching the low-temperature region of the boundary layer decreases and the overall thickness of the TEG 49, including the thickness of spacers in a direction of the heat flow, i.e. approximately normally to the skin surface, is reduced while still obeying the matching conditions in accordance with embodiments of the present invention. Proper positioning of the TEG 49 in the areas on a body of homeotherm where the boundary layer has the lower thickness may also help to decrease the required thickness of the TEG 49.

Positioning the TEG 49 on areas of the body of a homeotherm proximal to the body inner organs referred to as a core of the body, e.g. the brain, may allow further increase of the generated power as has been found in experiments. In case of a human being, the optimal position of the TEG 49 is on the temples of his head and on his forehead. In this case, the TEG 49 becomes effective also during nocturnal time, i.e. on a sleeping person. For a sleeping person, however, in case of a TEG 49 on a temple, both temples preferably have to be provided with TEGs 49 in case one of them is positioned on the pillow and thus producing lower power.

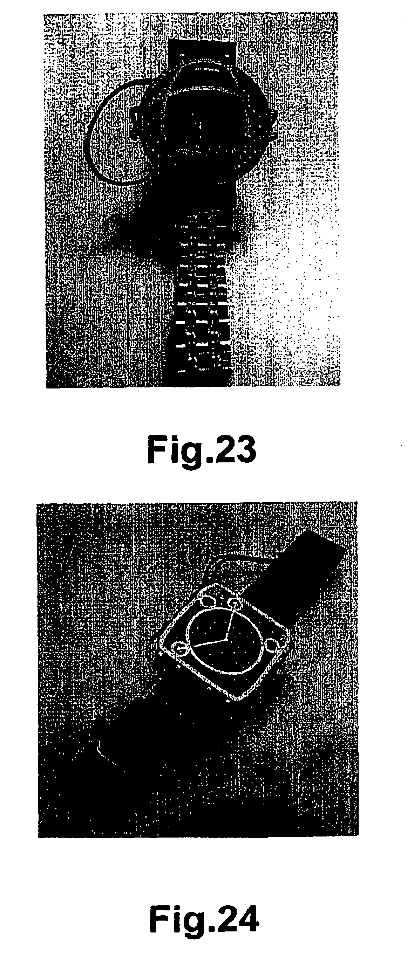

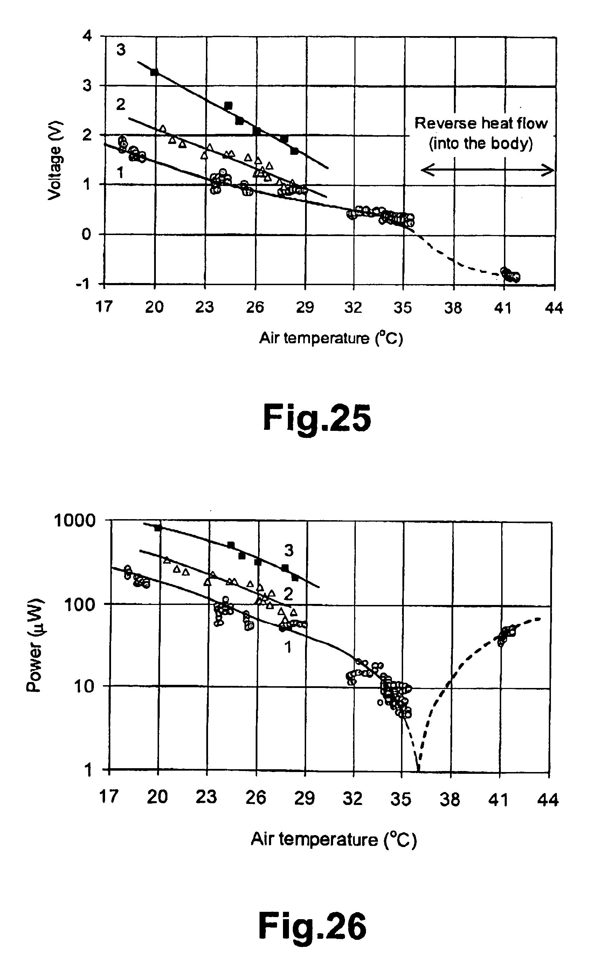

In Figs. 23, 24 photos of practical devices made in accordance with embodiments of the present invention are shown. The measured performance of these devices is reported in Figs. 25, 26, showing the open circuit voltage and the power as a function of air temperature. For both Fig. 25 and Fig. 26, curve (1) refers to measurements on a person quietly sitting for a very long time (hours) with no intermediate activity; curve (2) is obtained when a person performs usual office activity (walking in between offices, working on PC, etc.) in between the measurements, however, at least 5-10 minutes before the measurements, all activity is interrupted, and (3) is measured on a person walking indoor at about 4 km/hr.

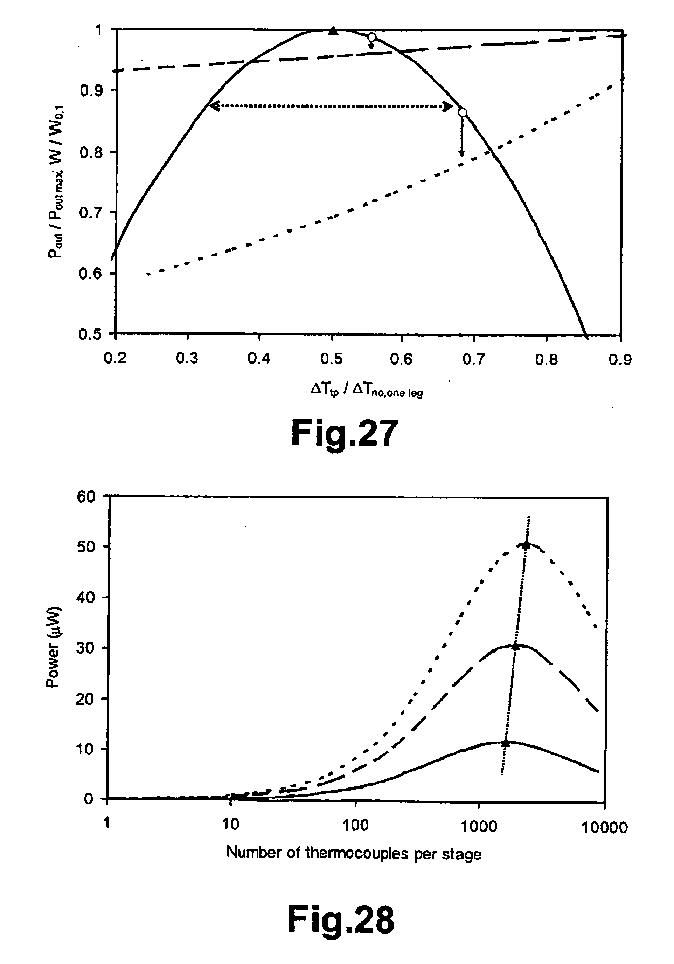

In order to quantify the effect of embodiments of the invention, examples of calculations have been performed for three types of thermopiles: for a commercially available thermopile and for two different micromachined thermopiles. The calculation of the commercially available thermopile is performed using an example of a bismuth telluride (BiTe) thermopile of a Seiko watch. It is assumed that the thermocouple legs are 0.6 mm long, their lateral size is 0.8 mm, and the area occupied by one leg cannot be less than $0.2 \times 0.2$ mm$^2$, which can be considered as the state of the art in industrial technologies. The thermal resistance of the body is 440 cm$^2$K/W in the location of the watch, the air temperature is 22 °C. It is assumed that the radiating area of the watch embodiment is 7 cm$^2$ and the contact area of the watch with the wrist is a circle of 2 cm in diameter. 10 thermopile chips of $2 \times 2$ mm$^2$ each are used in the watch. In such arrangement, the thermopile is not well suited for application on a human body, because the thermal resistance of the thermopile is mismatched to both the thermal resistance of the ambient air and to the thermal resistance of the body. The matching condition on state of the art approach cannot be reached, therefore a larger area of the chip is assumed, i.e. e.g. $1 \times 1$ cm$^2$, which is to replace 10 smaller units used in the watch. At this condition, the equality of the heat flow through the thermopile and through the air, as in the prior art matching condition, is reached at 1300 thermocouples on the chip, affording 11.8 $\mu$W power. The heat flow from the body changes by only 4% as compared with the case with no thermocouples in the TEG, or with only one thermocouple leg in it. If the conditions of matching in accordance with embodiments of the present invention are applied, 1620 thermocouples are needed for matching in accordance with embodiments of the invention. However, the TEG does not work efficiently and the heat flow from the body changes by only 4.5%. The effective TEG must induce significant change of the heat flow. The matching curve as needed for the prior art matching condition, plotted against the ratio $R_{th,tp} / R_{th,\,air\,in}$, is shown in Fig. 20, while for the matching conditions in accordance with embodiments of the present invention, the power is plotted in Fig. 21 versus $\Delta T_{tp} / \Delta T_{no,\,one\,leg}$ (solid line). The difference between the two matching conditions becomes clear from Fig. 27, where the results of a 10-stage thermopile and the results for a one-stage thermopile are both plotted. The matching curves for 1 stage and 10 stages coincide with each other if expressed in function of $\Delta T_{tp} / \Delta T_{no,one\,leg}$ (solid line). The heat flow through the TEG is shown as a dashed line for the 1-stage thermopile and as a dotted line for the 10-stage thermopile. In the latter case one can see large decrease of the heat flow W as compared with the case with no thermocouples or with 1 thermocouple leg $W_{0,\,1}$. The matching point (i.e., at the maximal power) stays at the same place (▲) for the matching in accordance with embodiments of the present invention, while for the prior art matching it moves from the upper point to a lower one, marked with (o) for both the case of a 1-stage and a 10-stage thermopile, with vertical arrows pointing at the corresponding heat flow. These prior art matching points do not reflect the true power optimum. As has been mentioned above, the thermopile under consideration is not well suited for a human body, as can be seen from the dashed heat flow curve, which does not show a large decrease near the matching point. A multi-stage arrangement, to the contrary, gives a large and advantageous decrease of the heat flow, as can be seen from the dotted line. In the case of 1- and 10-stage thermopile, the number of thermocouples corresponding to the matching (▲) in accordance with embodiments of the present invention offers maximum power, while the prior art matching does not.

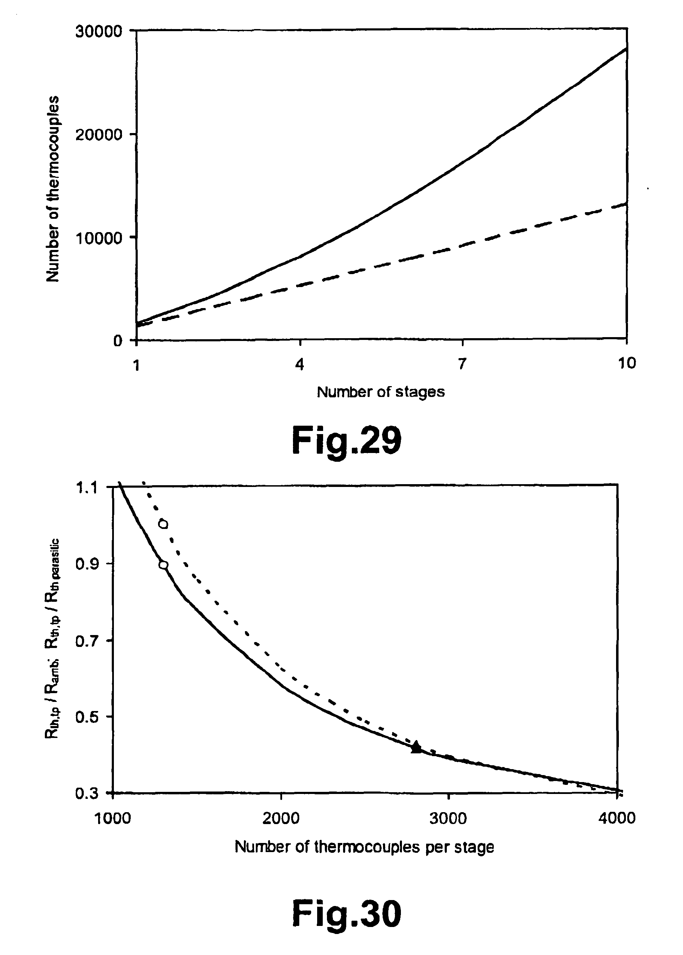

The dependence of absolute power on the number of thermocouples per stage, calculated for the case of 1 stage-, 3 stage- and 6-stage thermopiles as above is shown in Fig. 28 as solid, dashed and dotted curves, respectively. The dashed straight line shows that the point when matching is reached shifts in the direction of increasing number of thermocouples per stage for increased number of stages. At 10 stages, the power increases more than 5 times as compared to a one-stage TEG. The number of thermocouples required to reach the power maximum, calculated based on the matching condition in accordance with embodiments of the present invention (solid line) exceeds by about a coefficient of 2 the number of thermocouples obtained based on the prior art matching condition $R_{th,tp} = R_{th,\,air\,in}$ on several-stage thermopiles (dashed line), as illustrated in Fig. 29. The different number of required thermocouples for a same number of stages reflects different matching conditions.

Fig. 27 also suggests a useful range for a mismatching from the exact matching requirement in accordance with embodiments of the present invention, as already discussed above, marked with a horizontal arrow for a 10-stage thermopile. In this range, the generated power exceeds the one marked with (o) and corresponding to the prior art matching condition.

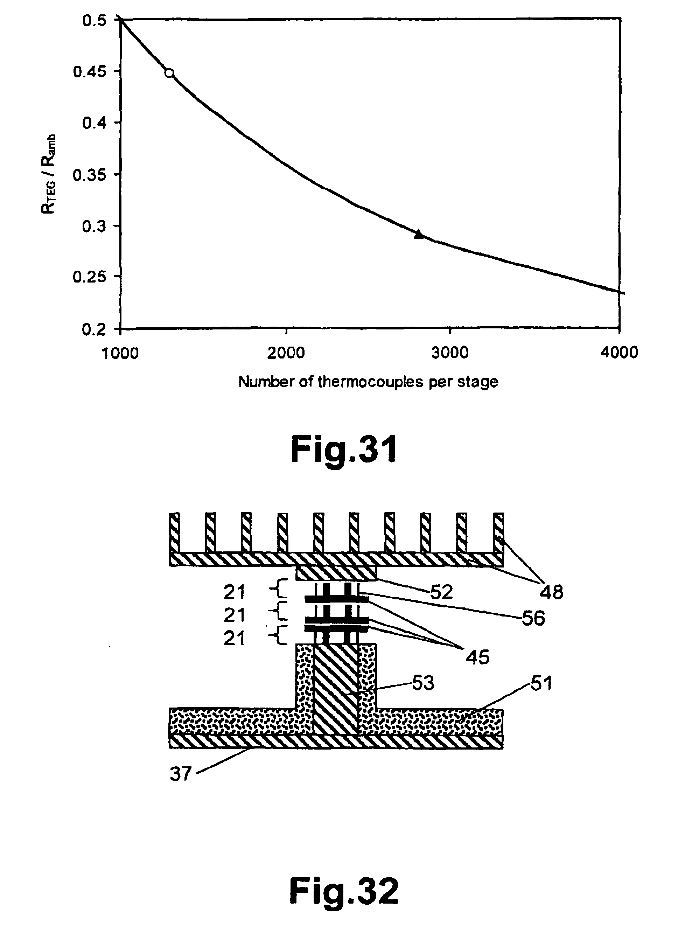

Fig. 30 shows the ratio of the thermal resistance of the thermopile due to conductivity through the thermopile legs to the serial resistance composed mainly of the thermal resistance of the heat source and the heat sink ($R_{th,tp} / R_{amb}$ - solid line), and the ratio of the thermal resistance of the thermopile to the parallel parasitic thermal resistance of the air in between the cold and hot plates ($R_{th,tp} / R_{th}$ parasitic - dashed line). Fig. 31 shows the ratio of the thermal resistance of the TEG to the serial resistance composed mainly of the thermal resistance of the heat source and the heat sink ($R_{TEG}$ / $R_{amb}$). In Figs. 30, 31 the ratios are shown for a 10-stage thermopile with the optimal points in accordance with embodiments of the present invention (▲) and according to prior art (o). It can easily be seen that the different matching conditions lead to quite different results, more particularly to quite different numbers of thermocouples per stage.

The present invention, in particular the matching condition to be applied for calculation of the number of thermocouples required in the thermopile or thermopile stage, is especially dedicated to "difficult" sources of heat for energy scavenging, i.e. e.g. with very low thermal gradients and very high thermal resistance. Therefore, the case of the commercially available thermopile calculated above does not show all advantages of the methods and devices according to embodiments of the present invention. Micromachined thermopiles could be better suited for such applications. More in particular, thermopiles as in EP 1 612 870 but with a number of thermocouples calculated according to embodiments of the present invention can provide a good thermal matching to such kind of heat source.

A micromachined thermopile on a raised elongate structure 53 made according to EP 1 612 870, which is referred to herein as a spacer, is now considered. One of the possible arrangements for a three-stage TEG is shown in Fig. 32, where the thermopile stages 21 are shown separated from each other for better understanding of the design. Two cases will be discussed: a thermopile well-optimised in accordance with embodiments of the present invention and a lower quality thermopile not optimised according to the present invention, e.g. optimized in accordance with the prior art. Then the effects or results will be compared. Differences between the different effects of the matching in accordance with embodiments of the present invention and multi-stage arrangement of the TEG in accordance with embodiments of the present invention will be made clear.

As an example, a well-optimised thermopile made of bismuth telluride according to EP 1 612 870 is supposed to be placed on an artery with a body thermal resistance of 200 cm²K/W. The thermocouples are 5 μm tall with a lateral size of 1 μm. One thermocouple occupies $10 \times 10$ μm² area of the die on top of the spacer 53. The thermopile chip 45 of $1 \times 1$ cm² size is assumed to have a thickness of 1 mm and the material properties are again as in Table I. Different numbers of thermopile chips 45 are placed in between the hot plate 37 of $3 \times 3$ cm² size and the radiator 48 with fins or pins having $3 \times 3$ cm² size and an effective contact area to the air of 18 cm² due to fins or pins. The radiator 48 is placed at 1 cm distance from the hot plate 37 where the Rayleigh/Reynolds of the heat transfer at the surface of the cold plate (38) or at the surface of the radiator (48) numbers are increased due to decoupling them from the ones on the skin. As in the previous example, the ambient air temperature is 22 °C. In order to thermally connect the hot plate 37, thermopile chip 45 and the radiator 48, spacers 52, 53 may be necessary if the number of chips 45 is less than 10. In order to hold the radiator 48 and the chips 45 on top of the thermopiles without damaging them, each thermopile stage 21 has a number of, e.g. four, silicon pillars 56 of $10 \times 10$ μm² lateral size with 7440 K/W thermal resistance parallel to thermopiles, i.e. a parasitic thermal resistance.

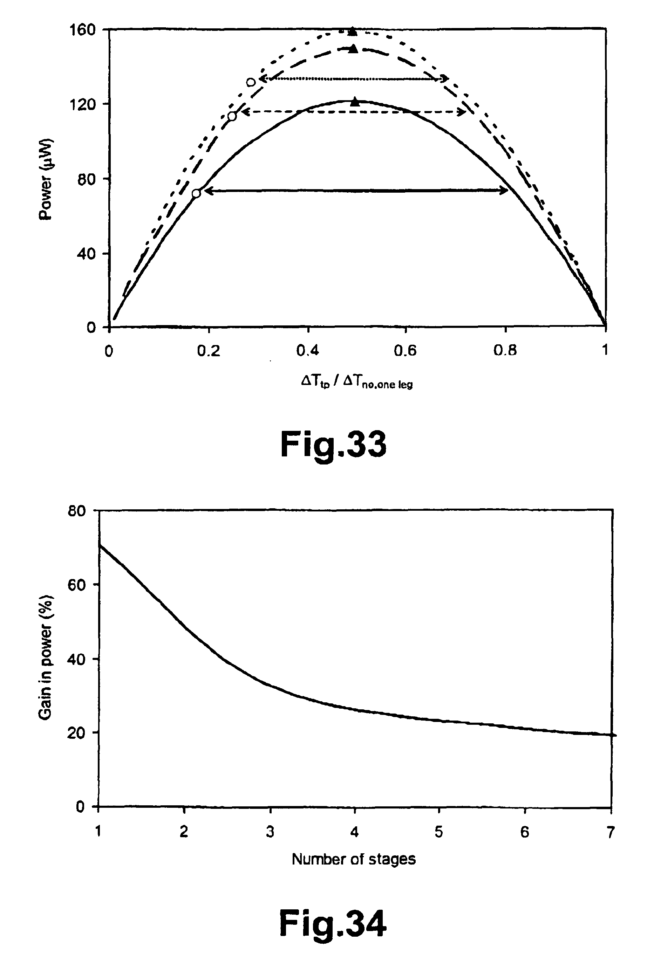

Fig. 33, solid line, shows the results of the modelling of a one-stage thermoelectric generator according to EP 1 612 870. The circle, as before, shows the result of matching according to the prior art, and the triangle shows the result of matching in accordance with embodiments of the present invention, which is better with respect to power output, as can be appreciated from the graph of Fig. 33. The effect of a multi-stage arrangement is shown for a 3 stage- and a 6-stage thermopile, by the dashed and dotted curves, respectively. The horizontal arrows, as in Fig. 27, show the zones where the matching in accordance with embodiments of the present invention shows an advantage over the prior art in case a larger or lesser voltage than at the matching point (▲) is required, i.e. the degree of allowable mismatch in accordance with embodiments of the present invention. The multi-stage arrangement also offers better performance as compared to the one-stage thermoelectric generator according to EP 1 612 870 because the maximal power increases from about 120 μW to about 160 μW at the same size of the TEG embodiment.

Fig. 34 shows the gain in power due to the better matching in accordance with embodiments of the present invention, in function of the number of thermopile stages, as compared with prior art matching. It is shown that for a one-stage thermoelectric generator for which the number of thermocouples is calculated in accordance with the matching condition (8) of the present invention, the output power is about 70% higher than for a one-stage thermoelectric generator with the number of thermocouples calculated according to prior art matching. The gain in power decreases for an increasing number of stages, and amounts to about 20% for a 7-stage generator.

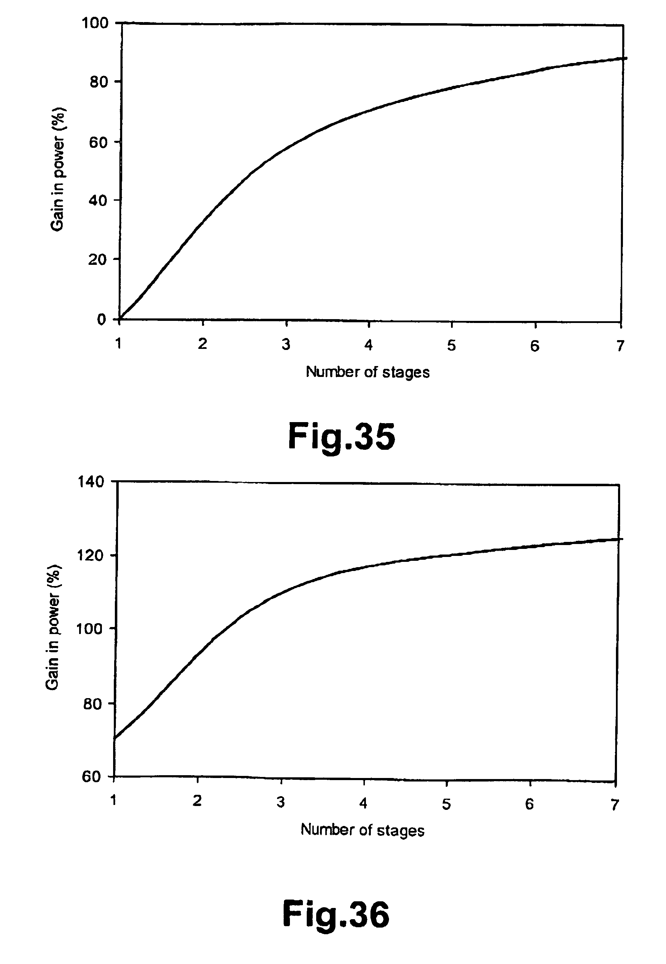

Fig. 35 shows the gain in power for a multi-stage design according to embodiments of the present invention, as compared with a one-stage thermoelectric generator according to EP 1 612 870, wherein the number of thermocouples is calculated according to prior art matching. Fig. 35 shows the effect of a multi-stage arrangement for prior-art thermoelectric generators. For the case considered here, the power generated by a two-stage thermoelectric generator is more than 30% higher than for a one-stage generator.

For a 7-stage generator, the gain in power is about 90% as compared to a 1-stage generator.

Fig. 36 is a sum of both effects shown in Figs. 34 and 35, proving that the effects are independent, and summation with each other gives about 70% rise in power with a one-stage thermoelectric generator thermally matched according to the present invention and more than 2.2 times improvement in power for a 7-stage thermoelectric generator thermally matched according to the present invention, as compared with a 1-stage embodiment that is thermally matched according to the prior art.

When considering a further, third, example of the matching and multi-stage arrangement in accordance with embodiments of the present invention, a similar TEG as above, but less optimal, will be discussed. The device thickness is assumed to be 12 mm; the hot and cold plates are similar to each other in size and shape, and have a size of $3 \times 3$ cm$^2$ each and 1 mm thickness. Different numbers of thermopile stages as discussed in EP 1 612 870 will be used; the stages are 1 mm thick, as in the previous example. It is now assumed that thermocouple legs are 3 $\mu$m long with a lateral size of 1 $\mu$m; one thermocouple leg occupies an area of $20 \times 20$ $\mu$m$^2$ on the chip surface. Thermocouples are made of polycrystalline silicon germanium with thermal conductivity of 0.03 W/ cm.K, electrical resistivity 2 m$\Omega$.cm and a Seebeck coefficient of 0.1 mV/K. The shock protection and mechanical stiffness of the TEG 49 is provided with a polymer wall of 1 mm thick on the perimeter of the device connecting the hot and cold plates and encapsulating its inner volume, but making a parasitic thermal conductance of 658 K/W.

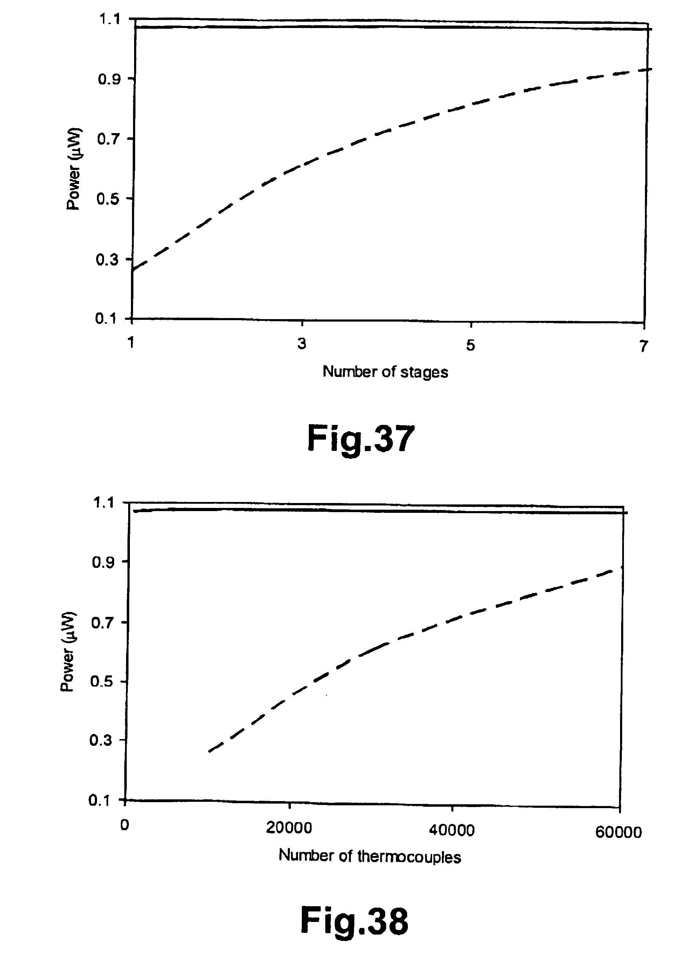

In the design under consideration, the parasitic thermal conductance through the air on top of the on-chip spacer exceeds the useful conductance through the thermopile, so it is actually not a well-suited device for the chosen application. Therefore, the increased number of the stages does not offer the corresponding rise of the power, as illustrated in Fig. 37, solid line. The dashed line, however, which shows the matching in accordance with the prior art, lies well below the solid line, once more confirming the advantageous effect of the matching in accordance with embodiments of this invention. Matching according to the present invention also has an advantageous effect as compared to prior art matching, for a given number of thermocouples. This is depicted in Fig. 38, where the solid line is for the present invention and the dashed one is for the prior art. It is clear from Figs. 37, 38 that if a larger voltage is required than the one obtained at the optimal point, a thermal mismatch in accordance with embodiments of the present invention can be performed because, e.g., at one stage, a 4-fold improvement in generated power is obtained for embodiments in accordance with the present invention, compared to the prior art situation.

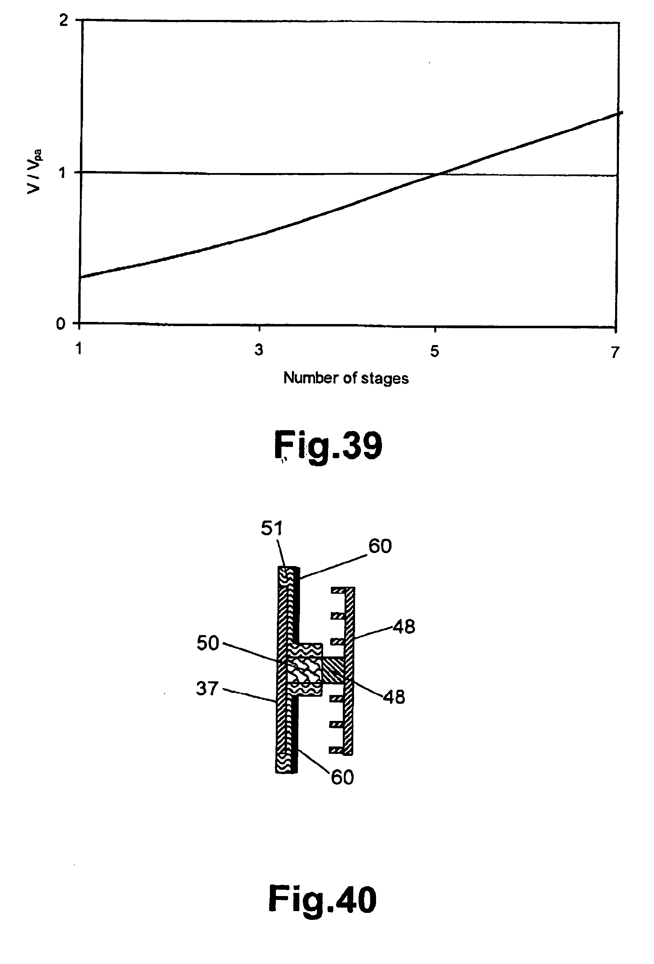

Fig. 39, in addition, shows one more advantage of the matching in accordance with embodiments of the present invention for the case under consideration. When the number of stages exceeds 5, the voltage also exceeds the prior art level $V_{pa}$ together with the power. It increases to about 140% as compared to the prior art at 7 stages, and it further increases up to two-fold improvement as compared to the prior art at 10 stages (extrapolation).

To prevent or suppress the radiation heat exchange inside the TEG 49, one or more, and preferably all, inner surfaces of the TEG 49 may have low emissivity (lower than 20%, preferably lower than 10%) in the infrared region of the electromagnetic spectrum. For example, a number of metals may serve as low-emissivity materials. Thus, if plastics or other materials used for forming the TEG 49, have high emissivity, they preferably are covered with highly reflecting (low emissivity) material, such as for example a metal. The inner surfaces of the TEG are the surfaces of the structures comprised in the TEG, in between the hot plate (37) and the cold plate (38) or the radiator (48).

For better thermal isolation of the cold plate 38 or/and radiator 48 from the warmer parts of the TEG 49 and a heat source, the inner volume of the TEG 49 as well as the volume on or in between the thermopile stages 21 (or in between chips 45, 46, if heat-spreading chips 46 are used) can be filled with a material showing lower thermal conductivity than the ambient, for example air, e.g. a microporous or nanoporous material. This is especially related to the TEGs in accordance with embodiments of the present invention which are incorporated into a garment, when their thickness may be reduced as compared with a TEG on open skin surface, due to reduced temperature as compared with the skin temperature under the clothes.

In order to increase radiant heat exchange from an inner surface of the radiator 48 or from the cold plate 38 into the ambient, the inner surface of the radiator or of the cold plate preferably has a high emissivity (higher than 90%, preferably higher than 95%) in the wavelength range of thermal radiation (e.g. between 7 $\mu$m and 14 $\mu$m). Then, the inner surface of the hot plate 37 may have a low emissivity (lower than 20%, preferably lower than 10%) in the infrared region. A TEG 49 according to a further embodiment of the present invention is preferably provided with a shield or screen 60 with a low emissivity in the infrared region. The screen 60 may be installed in between and thermally isolated, for example by means of thermal isolation 51, from the hot plate 37 and the cold plate 38 or radiator 48. This is illustrated in Fig. 40.

As the TEG 49 according to embodiments of the present invention may also be used for outdoor applications at temperatures above body core temperature and with a radiant heat from sun or from ambient (e.g. in a desert when the sand is heated to e.g. about 40-90 °C), the TEG 49 may be used in reverse mode of operation, i.e. when the heat flow direction is from the ambient into a body, or to another surface, on which the device is mounted. For this type of applications, the outer surface of the cold plate 38 or radiator 48 must have a low absorption in the visible and near-infrared spectral regions, but may still have a high emissivity in the far-infrared, where the radiator emits thermal radiation. The measured voltage generation on a practical device in reverse mode is illustrated in Fig. 25 at temperatures of 41-42 °C; the correspondingly generated power can be seen in Fig. 26.

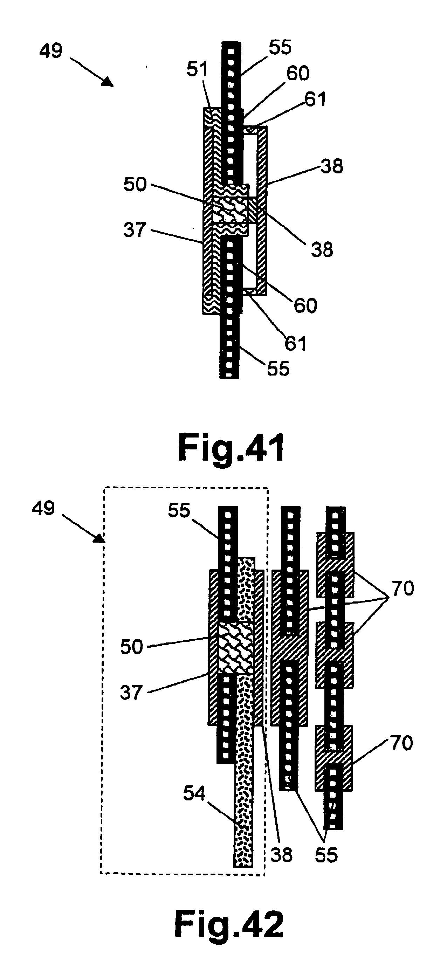

Fig. 41 shows a cross-section of a possible implementation of a TEG 49 according to one of the embodiments of the present invention. According to this embodiment, the TEG 49 may be mounted as a "button" or a series of "buttons" in a garment 55 (like in EP 1 612 870), see also Fig. 22. The separate units 49 may be interconnected electrically with each other. The hot plate 37 and the cold plate 38 or the radiator 48 can be made flexible for convenience of the wearer and also for decreasing the mechanical shocks when wearing the TEG 49 or during laundry of the garment 55. The hot plate 37 must preferably be larger than the outer size of the thermopile unit 50, the outer size of the thermopile unit 50 being determined in a plane parallel to the hot plate 37, preferably at least twice as large, more preferred at least three times as large, to satisfy the matching conditions in accordance with the present invention and to provide low thermal resistance of the air in between the TEG 49 and the skin in a standard case when the garment 55 is not tight. Tightening bands or threads, preferably elastic tightening bands or threads, can optionally also be added to the clothes for better mechanical and therefore also better thermal contact to the skin. The shown example of the device contains thermally isolating pillars 61 or an encapsulating wall 61 on the perimeter of the cold plate 38. The inner volume in between the plates 37, 38, in embodiments of a TEG in accordance with the present invention, can be, but does not need to be, completely filled with thermally isolating material other than air, e.g. a nanoporous material. A part of the inner volume may also be used for the accompanying electronic module for power conditioning, energy storage and other useful functions depending on specificity of the application, e.g. for sensor nodes.

In case a person wears several pieces of garment on top of each other, heat transferring structures 70 like in the example shown in Fig. 42 could be implemented in the layers of the cloth worn under/above the garment layer with the TEG 49. The device represents in this case two or more components separately fabricated in two or more pieces of the garment. The TEG 49 can be, of course, implemented into any of the garment layers. The quantity, size and spread of the heat transferring structures 70 in the cloth must guarantee proper thermal contacting with the TEG 49. This may mean not only a physical contact but also a small distance in between the heat transferring structures and the TEG 49, which still provides reasonable performance of the TEG 49. Magnetic clamping of the heat transferring structures 70 to the TEG 49 or between heat transferring structures 70 in different garment layers 55 can be implemented furthermore, similar to what is disclosed in EP 1 612 870. The heat transferring structures 70 can be made of metal or any other suitable materials with high thermal conductivity, including flexible materials. The zones of the garment 55 where the heat transfer is needed may alternatively also be subject of locally introducing heat-conductive threads or yarns, e.g. metallic threads, instead of using heat transferring structures 70 as shown in Fig. 42.

**Claims**

1. A thermoelectric generator (49) for connection between a heat source and a heat sink, the thermoelectric generator (49) comprising a thermopile unit (50), said thermopile unit (50) comprising at least one thermopile stage (21), each thermopile stage (21) comprising a number of thermocouples (10) each having a couple of thermocouple legs (11, 12), the thermocouple legs (11, 12) being provided in between a hot junction plane (24) and a cold junction plane (25), wherein the number of thermocouples (10) is such that the thermal resistance ($R_{TEG}$) of the thermoelectric generator (49) between the hot junction plane (24) comprising the hottest junctions of a thermopile stage (21) and the cold junction plane (25) comprising the coldest junctions of the thermopile stage (21) does not deviate more than 50%, preferably not more than 20%, more preferred not more than 10%, still more preferred not more than 5% from the thermal resistance of the ambient ($R_{th,amb}$), being the sum of the thermal resistance of the heat source, the thermal resistance of the heat sink and the thermal resistance of all parts of the thermoelectric generator (49) serially coupled to the at least one thermopile stage (21), multiplied by the parasitic thermal resistance ($R_{TEG,0,1}$) between the hot junction plane (24) and the cold junction plane (25) for a same thermoelectric generator but comprising no thermocouples (10) or only one thermocouple leg (11, 12), this product being divided by the sum of the parasitic thermal resistance ($R_{TEG,0,1}$) between the hot junction plane (24) and the cold junction plane (25) for a same thermoelectric generator but comprising no thermocouples (10) or only one thermocouple leg (11, 12), summed with twice the thermal resistance of the ambient ($R_{th,0,1,amb}$), for a same thermoelectric generator but comprising no thermocouples (10) or only one thermocouple leg (11, 12).

2. The thermoelectric generator (49) according to claim 1, wherein at least one of said at least one thermopile stage (21) comprises at least one of a first plate (22) thermally connected to the junctions in said hot junction plane (24) and a second plate (23) thermally connected to the junctions in said cold junction plane (25).

3. The thermoelectric generator (49) according to claim 1 or 2, wherein said thermopile unit (50) is thermally connected to and positioned in between a hot plate (37) for connection to the heat source and a cold plate (38) for connection to the heat sink.

4. The thermoelectric generator (49) according to claim 3, said thermoelectric generator (49) furthermore comprising a radiator (48) mounted on or placed instead of the cold plate (38).

5. The thermoelectric generator (49) according to claim 3 or 4, wherein the surface area of the hot plate (37) is larger than the area of the thermopile unit (50), the area of the thermopile unit (50) being determined in a plane parallel to the hot plate (37) and/or wherein the surface area of the cold plate (38) is larger than the area of the thermopile unit (50), the area of the thermopile unit (50) being determined in a plane parallel to the cold plate (38).

6. The thermoelectric generator (49) according to any of the previous claims, further comprising at least one thermally conductive spacer (52, 53) between the at least one thermopile stage (21) and the hot plate (37) and/or the cold plate (38) and/or the radiator (48) and/or between two of the at least one thermopile stages (21).

7. The thermoelectric generator (49) according to any of the previous claims, wherein the thermopile unit (50) comprises more than one thermopile stage (21) to improve the Rayleigh number or Reynolds number of the heat transfer at the surface of the cold plate (38) or at the surface of the radiator (48) as compared with the same thermoelectric generator (49) with one thermopile stage (21).

8. The thermoelectric generator (49) according to claim 3 to claim 7, said thermoelectric generator (49) furthermore comprising a thermal reflector (60) positioned in between the hot plate (37) and the cold plate (38), said thermal reflector (60) covering the hot plate (37), the cold plate (38), the radiator (48), the first plate (22) and/or the second plate (23) and being thermally isolated therefrom.

9. The thermoelectric generator (49) according to any of the previous claims, wherein said thermocouples are micromachined thermocouples.

10. The thermoelectric generator (49) according to any of the previous claims, wherein said thermocouples (10) are positioned on a polymer tape or on a membrane, or wherein thin/thick-film thermocouples (10) without a substrate are used.

11. The thermoelectric generator (49) according to any of the previous claims, wherein at least one of said at least one thermopile stage (21) comprises a thermally conductive structure forming a thermal interconnection between the thermocouple legs (11, 12) and at least one of the cold plate (37), the hot plate (38), and the radiator (48), said thermally conductive structure comprising a thin/thick film of thermally conductive material or a substrate material.

12. The thermoelectric generator (49) according to any of the previous claims, wherein said thermoelectric generator (49) is filled at least partially with thermally isolating material.

13. A thermoelectric generator (49) according to any of claim 3 to claim 12, wherein the inner volume of said thermoelectric generator (49) is encapsulated on its perimeter between the hot plate (37) and the cold plate (38) or the radiator (48), using a layer of thermally isolating material.

14. A thermoelectric generator (49) according to claim 13 wherein the volume between the hot plate (37) and the cold plate (38) or the radiator (48) is filled with a gas having lower thermal conductivity than air or which is at a pressure that is lower than the atmospheric pressure.

15. A thermoelectric generator (49) according to any of claims 3 to 14, wherein the inner surface of said hot plate (37) or the inner surface of said thermal reflector (60), being the surface not facing the heat source, has low emissivity, preferably lower than 20%, more preferred lower than 10%, in the infrared region, and wherein the inner surface of said cold plate (38) or the inner surface of said radiator (48), being the surface not facing the heat sink, has high emissivity, preferably higher than 90%, more preferred higher than 95%, in the infrared region.

16. A method for designing a thermoelectric generator (49) for connection between a heat source and a heat sink and with a limited heat flow through the thermoelectric generator (49) and a non-constant temperature difference between the heat source and the heat sink, the thermoelectric generator (49) comprising a thermopile unit (50), said thermopile unit (50) comprising at least one thermopile stage (21), each thermopile stage comprising a number of thermocouples (10) each having a couple of thermocouple legs (11, 12), the thermocouple legs (11, 12) being provided in between a hot junction plane (24) comprising the hottest junctions of a thermopile stage (21) and a cold junction plane (25) comprising the coldest junctions of a thermopile stage (21), the method comprising:

determining the thermal resistance ($R_{TEG}$) of the thermoelectric generator (49) between the hot junction plane (24) and the cold junction plane (25) as a function of the number of thermocouples (10);
determining the sum ($R_{th,amb}$) of the thermal resistance of the heat source, the thermal resistance of the heat sink and the thermal resistance of all parts of the thermoelectric generator serially coupled to the at least one thermopile stage (21), as a function of the number of thermocouples (10);

determining the parasitic thermal resistance ($R_{TEG,0,1}$) between the hot junction plane (24) and the cold junction plane (25) for a same thermoelectric generator but comprising no thermocouples (10) or only one thermocouple leg (11, 12);

determining the sum ($R_{th,0,1,amb}$) of the thermal resistance of the heat source, the thermal resistance of the heat sink and the thermal resistance of all parts of the thermoelectric generator serially coupled to the at least one thermopile stage (21), for a same thermoelectric generator but comprising no thermocouples (10) or only one thermocouple leg (11, 12);

dividing the product of $R_{th,amb}$ and $R_{TEG,0,1}$ by the sum of $R_{TEG,0,1}$ and twice $R_{th,0,1,amb}$, resulting in a thermal resistance value; and

adapting the number of thermocouples (10) such that the thermal resistance ($R_{TEG}$) of the thermoelectric generator (49) between the hot junction plane (24) and the cold junction plane (25) does not deviate more than 50%, preferably not more than 20%, more preferred not more than 10%, still more preferred not more than 5% from said thermal resistance value.

17. The method for designing a thermoelectric generator (49) according to claim 16, wherein said thermopile unit (50) is thermally connected to and positioned in between a hot plate (37) for connection to the heat source and a cold plate (38) for connection to the heat sink.

18. The method for designing a thermoelectric generator (49) according to claim 17, wherein the thermoelectric generator comprises a radiator (48) mounted on or placed instead of the cold plate (38).

19. The method for designing a thermoelectric generator (49) according to any of claims 16 to 18, furthermore comprising varying the shape and/or the size of at least one of the hot plate (37) and the cold plate (38) and the radiator (48).

20. The method for designing a thermoelectric generator (49) according to any of claims 16 to 19, wherein the thermoelectric generator (49) comprises at least one thermally conductive spacer (52, 53) in between the at least one thermopile stage (21) and the hot plate (37) and/or the cold plate (38) and/or the radiator (48) and/or between two of the thermopile stages (21).

21. A computer program product for executing a method for designing a thermoelectric generator according to any of claims 16 to 20.

22. A machine readable data storage device storing the computer program product of claim 21.

23. Transmission of the computer program product of claim 21 over a local or wide area telecommunications network.

24. The use of the thermoelectric generator (49) according to any of claim 1 to claim 15, wherein said heat source is an animal, a human being, a clothed human being or ambient air and wherein said heat sink is ambient air, an animal, a human being or a clothed human being.

25. The use of the thermoelectric generator (49) according to any of claim 1 to claim 15, wherein said heat source is a space object or an artificial space object and wherein said heat sink is interplanetary space, a space object or an artificial space object.

26. The use of the thermoelectric generator (49) according to any of claim 1 to claim 15, wherein said heat source is a distant radiating object or a plurality of distant radiating objects like space objects or ambient objects and wherein the heat sink is Earth surface.

**Patentansprüche**

1. Thermoelektrischer Generator (49) zur Verbindung zwischen einer Wärmequelle und einer Wärmesenke, wobei der thermoelektrische Generator (49) eine thermophile Einheit (50) umfasst, wobei die thermophile Einheit (50) mindestens eine thermophile Stufe (21) umfasst, wobei jede thermophile Stufe (21) eine Anzahl von Thermosonden (10) umfasst, die jeweils ein Paar von Thermosondenschenkeln (11, 12) aufweisen, wobei die Thermosondenschenkel (11, 12) zwischen einer Hochtemperaturverbindungsebene (24) und einer Niedertemperaturverbindungsebene (25) bereitgestellt sind,
wobei die Anzahl von Thermosonden (10) derart ist, dass der Wärmewiderstand ($R_{TEG}$) des thermoelektrischen Generators (49) zwischen der Hoohtemperaturverbindungsebene (24), die die heißesten Verbindungen einer thermophilen Stufe (21) umfasst, und der Niedertemperaturverbindungsebene (25), die die kältesten Verbindungen der thermophilen Stufe (21) umfasst, nicht mehr als 50%, vorzugsweise nicht mehr als 20%, insbesondere nicht mehr als 10%, noch bevorzugter nicht mehr als 5% von dem Wärmewiderstand der Umgebung ($R_{th,amb}$) abweicht, der die Summe des Wärmewiderstandes der Wärmequelle, des Wärmewiderstandes der Wärmesenke und des Wärmewiderstandes aller Teile des thermoelektrischen Generators (49), die seriell an die mindestens eine thermophile Stufe (21) gekoppelt sind, multipliziert mit dem parasitären Wärmewiderstand ($R_{TEG,0,1}$) zwischen der Hochtemperaturverbindungsebene (24) und der Niedertemperaturverbindungsebene (25) für denselben thermoelektrischen Generator ist, aber ohne Thermosonden (10) oder mit nur einem Thermosondenschenkel (11, 12), wobei dieses Produkt durch die Summe des parasitären Wärmewiderstandes ($R_{TEG,0,1}$) zwischen der Hochtemperaturverbindungsebene (24) und der Niedertemperaturverbindungsebene (25) für denselben thermoelektrischen Generator, aber ohne Thermosonden (10) oder mit nur einem Thermosondenschenkel (11, 12) dividiert wird, summiert mit dem Zweifachen des Wärmewiderstandes der Umgebung ($R_{th,0,1,amb}$) für denselben thermoelektrischen Generator, aber ohne Thermosonden (10) oder mit nur einem Thermosondenschenkel (11, 12).

2.  Thermoelektrischer Generator (49) nach Anspruch 1, wobei mindestens eine der mindestens einen thermophilen Stufe (21) mindestens eine von einer ersten Platte (22), die thermisch mit den Verbindungen in der Hochtemperaturverbindungsebene (24) verbunden ist, und einer zweiten Platte (23), die thermisch mit den Verbindungen in der Niedertemperaturverbindungsebene (25) verbunden ist, umfasst.

3.  Thermoelektrischer Generator (49) nach Anspruch 1 oder 2, wobei die thermophile Einheit (50) thermisch an eine Hochtemperaturplatte (37) zur Verbindung mit der Wärmequelle und eine Niedertemperaturplatte (38) zur Verbindung mit der Wärmesenke angeschlossen und zwischen diesen positioniert ist.

4.  Thermoelektrischer Generator (49) nach Anspruch 3, wobei der thermoelektrische Generator (49) des Weiteren einen Radiator (48) umfasst, der an der Niedertemperaturplatte (38) montiert oder anstelle dieser angeordnet ist.

5.  Thermoelektrischer Generator (49) nach Anspruch 3 oder 4, wobei die Oberfläche der Hochtemperaturplatte (37) größer ist als die Fläche der thermophilen Einheit (50), wobei die Fläche der thermophilen Einheit (50) in einer Ebene parallel zu der Hochtemperaturplatte (37) bestimmt wird und/oder wobei die Oberfläche der Niedertemperaturplatte (38) größer als die Fläche der thermophilen Einheit (50) ist, wobei die Fläche der thermophilen Einheit (50) in einer Ebene parallel zu der Niedertemperaturplatte (38) bestimmt wird.

6.  Thermoelektrischer Generator (49) nach einem der Vorangehenden Ansprüche, des Weiteren umfassend mindestens einen Wärme leitenden Abstandshalter (52, 53) zwischen der mindestens einen thermophile Stufe (21) und der Hochtemperaturplatte (37) und/oder der Niedertemperaturplatte (38) und/oder dem Radiator (48) und/oder zwischen zwei der mindestens einen thermophilen Stufe (21).

7.  Thermoelektrischer Generator (49) nach einem der vorangehenden Ansprüche, wobei die thermophile Einheit (50) mehr als eine thermophile Stufe (21) umfasst, um die Rayleigh-Zahl oder Reynolds-Zahl der Wärmeübertragung an der Oberfläche der Niedertemperaturplatte (38) oder an der Oberfläche des Radiators (48) im Vergleich zu demselben thermoelektrischen Generator (49) mit einer thermophilen Stufe (21) zu verbessern.

8.  Thermoelektrischer Generator (49) nach Anspruch 3 bis Anspruch 7, wobei der thermoelektrische Generator (49) des Weiteren einen Wärmereflektor (60) umfasst, der zwischen der Hochtemperaturplatte (37) und der Niedertemperaturplatte (38) positioniert ist, wobei der Wärmereflektor (60) die Hochtemperaturplatte (37), die Niedertemperaturplatte (38), den Radiator (48), die erste Platte (22) und/oder die zweite Platte (23) bedeckt und von diesen Wärme isoliert ist.

9.  Thermoelektrischer Generator (49) nach einem der vorangehenden Ansprüche, wobei die Thermosonden mikromaschinell bearbeitete Thermosonden sind.

10. Thermoelektrischer Generator (49) nach einem der vorangehenden Ansprüche, wobei die Thermosonden (10) auf einem Polymerband oder auf einer Membran positioniert sind, oder wobei Dünn/Dickfilm-Thermosonden (10) ohne Substrat verwendet werden.

**11.** Thermoelektrischer Generator (49) nach einem der vorangehenden Ansprüche, wobei mindestens eine der mindestens einen thermophilen Stufe (21) eine Wärme leitende Struktur umfasst, die eine Wärmeverbindung zwischen den Thermosondenschenkeln (11, 12) und mindestens einem von der Hochtemperaturplatte (37), der Niedertemperaturplatte (38) und dem Radiator (48) bildet, wobei die Wärme leitende Struktur einen Dünn/Dickfilm aus Wärme leitendem Material oder ein Substratmaterial umfasst.

**12.** Thermoelektrischer Generator (49) nach einem der vorangehenden Ansprüche, wobei der thermoelektrische Generator (49) mindestens teilweise mit Wärme isolierendem Material gefüllt ist.

**13.** Thermoelektrischer Generator (49) nach einem der Ansprüche 3 bis 12, wobei das Innenvolumen des thermoelektrischen Generators (49) an seinem Umfang zwischen der Hochtemperaturplatte (37) und der Niedertemperaturplatte (38) oder dem Radiator (48) unter Verwendung einer Schicht aus Wärme isolierendem Material eingekapselt ist.

**14.** Thermoelektrischer Generator (49) nach Anspruch 13, wobei das Volumen zwischen der Hochtemperaturplatte (37) und der Niedertemperaturplatte (38) oder dem Radiator (48) mit einem Gas gefüllt ist, das eine geringere Wärmeleitfähigkeit als Luft hat oder das bei einem Druck ist, der geringer als atmosphärischer Druck ist.

**15.** Thermoelektrischer Generator (49) nach einem der Ansprüche 3 bis 14, wobei die Innenfläche der Hochtemperaturplatte (37) oder die Innenfläche des Wärmereflektors (60), die die Oberfläche ist, die nicht der Wärmequelle zugewandt ist, ein geringeres Emissionsvermögen, vorzugsweise geringer als 20%, insbesondere geringer als 10%, im Infrarotbereich hat, und wobei die Innenfläche der Niedertemperaturplatte (38) oder die Innenfläche des Radiators (48), die die Oberfläche ist, die nicht der Wärmesenke zugewandt ist, ein höheres Emissionsvermögen, vorzugsweise höher als 90%, insbesondere höher als 95%, im Infrarotbereich hat.

**16.** Verfahren zur Konstruktion eines thermoelektrischen Generators (49) zur Verbindung zwischen einer Wärmequelle und einer Wärmesenke und mit einem begrenzten Wärmestrom durch den thermoelektrischen Generator (49) und einer nicht konstanten Temperaturdifferenz zwischen der Wärmequelle und der Wärmesenke, wobei der thermoelektrische Generator (49) eine thermophile Einheit (50) umfasst, wobei die thermophile Einheit (50) mindestens eine thermophile Stufe (21) umfasst, wobei jede thermophile Stufe (21) eine Anzahl von Thermosonden (10) umfasst, die jeweils ein Paar von Thermosondenschenkeln (11, 12) aufweisen, wobei die Thermosondenschenkel (11, 12) zwischen einer Hochtemperaturverbindungsebene (24), die die heißesten Verbindungen einer thermophilen Stufe (21) umfasst, und einer Niedertemperaturverbindungsebene (25), die die kältesten Verbindungen der thermophilen Stufe (21) umfasst, bereitgestellt sind, wobei das Verfahren umfasst:

Bestimmen des Wärmewiderstandes ($R_{TEG}$) des thermoelektrischen Generators (49) zwischen der Hochtemperaturverbindungsebene (24) und der Niedertemperaturverbindungsebene (25) als Funktion der Anzahl von Thermosonden (10);
Bestimmen der Summe ($R_{th,amb}$) des Wärmewriderstandes der Wärmequelle, des Wärmewiderstandes der Wärmesenke und des Wärmewiderstandes aller Teile des thermoelektrischen Generators, die seriell an die mindestens eine thermophile Stufe (21) gekoppelt sind, als Funktion der Anzahl von Thermosonden (10);
Bestimmen des parasitären Wärmewiderstandes ($R_{TEG,0,1}$) zwischen der Hochtemperaturverbindungsebene (24) und der Niedertemperaturverbindungsebene (25) für denselben thermoelektrischen Generator, aber ohne Thermosonden (10) oder mit nur einem Thermosondenschenkel (11, 12);
Bestimmen der Summe ($R_{th,0,1amb}$) des Wärmewiderstandes der Wärmequelle, des Wärmewiderstandes der Wärmesenke und des Wärmewiderstandes aller Teile des thermoelektrischen Generators (49), die seriell an die mindestens eine thermophile Stufe (21) gekoppelt sind, für denselben thermoelektrischen Generator, aber ohne Thermosonden (10) oder mit nur einem Thermosondenschenkel (11, 12);
Dividieren des Produkts von $R_{th,amb}$ und $R_{TEG,0,1}$ durch die Summe von $R_{TEG,0,1}$ und dem zweifachen $R_{th,0,1,amb}$, wodurch ein Wärmewiderstandswert erhalten wird; und
Anpassen der Anzahl von Thermosonden (10) derart, dass der Wärmewiderstand ($R_{TEG}$) des thermoelektrischen Generators (49) zwischen der Hochtemperaturverbindungsebene (24) und der Niedertemperaturverbindungsebene (25) nicht mehr als 50%, vorzugsweise nicht mehr als 20%, insbesondere nicht mehr als 10%, noch bevorzugter nicht mehr als 5% von dem Wärmewiderstandswert abweicht.

**17.** Verfahren zur Konstruktion eines thermoelektrischen Generators (49) nach Anspruch 16, wobei die thermophile Einheit (50) thermisch an eine Hochtemperaturplatte (37) zur Verbindung mit der Wärmequelle und eine Niedertemperaturplatte (38) zur Verbindung mit der Wärmesenke angeschlossen und zwischen diesen positioniert ist.

**18.** Verfahren zur Konstruktion eines thermoelektrischen Generators (49) nach Anspruch 17, wobei der thermoelektrische Generator (49) einen Radiator (48) umfasst, der an der Niedertemperaturplatte (38) montiert oder anstelle dieser angeordnet ist.

**19.** Verfahren zur Konstruktion eines thermoelektrischen Generators (49) nach einem der Ansprüche 16 bis 18, des Weiteren umfassend das Variieren der Form und/oder der Größe mindestens eines von der Hochtemperaturplatte (37) und der Niedertemperaturplatte (38) und des Radiators (48).

**20.** Verfahren zur Konstruktion eines thermoelektrischen Generators (49) nach einem der Ansprüche 16 bis 19, wobei der thermoelektrische Generator (49) des Weiteren mindestens einen Wärme leitenden Abstandshalter (52, 53) zwischen der mindestens einen thermophilen Stufe (21) und der Hochtemperaturplatte (37) und/oder der Niedertemperaturplatte (38) und/oder dem Radiator (48) und/oder zwischen zwei der thermophilen Stufen (21) umfasst.

**21.** Computerprogramm zum Ausführen eines Verfahrens zur Konstruktion eines thermoelektrischen Generators nach einem der Ansprüche 16 bis 20.

**22.** Maschinenlesbare Datenspeichervorrichtung, die das Computerprogrammprodukt nach Anspruch 21 speichert.

**23.** Senden des Computerprogrammprodukts nach Anspruch 21 über ein lokales oder überregionales Telekommunikationsnetz.

**24.** Verwerdung des thermoelektrischen Generators (49) nach einem der Ansprüche 1 bis 15, wobei die Wärmequelle ein Tier, ein Mensch, ein bekleideter Mensch oder Umgebungsluft ist und wobei die Wärmesenke Umgebungsluft, ein Tier, ein Mensch oder ein bekleideter Mensch ist.

**25.** Verwendung des thermoelektrischen Generators (49) nach einem der Ansprüche 1 bis 15, wobei die Wärmequelle ein Raumobjekt oder ein künstliches Raumobjekt ist und wobei die Wärmesenke interplanetarer Raum, ein Raumobjekt oder ein künstliches Raumobjekt ist.

**26.** Verwendung des thermoelektrischen Generators (49) nach einem der Ansprüche 1 bis 15, wobei die Wärmequelle ein entferntes strahlendes Objekt oder eine Vielzahl von entfernten strahlenden Objekten, wie Raumobjekten, oder Umgebungsobjekten ist, und wobei die Wärmesenke die Erdoberfläche ist.

## Revendications

**1.** Générateur thermoélectrique (49) pour connexion entre une source de chaleur et un puits de chaleur, le générateur thermoélectrique (49) comprenant une unité formant thermopile (50), ladite unité formant thermopile (50) comprenant au moins un étage de thermopile (21), chaque étage de thermopile (21) comprenant un certain nombre de thermocouples (10), chacun ayant un couple de branches de thermocouple (11, 12), les branches de thermocouple (11, 12) étant disposées entre un plan de soudure chaude (24) et un plan de soudure froide (25),
dans lequel le nombre de thermocouples (10) est tel que la résistance thermique ($R_{TEG}$) du générateur thermoélectrique (49) entre le plan de soudure chaude (24) comprenant les soudures les plus chaudes d'un étage de thermopile (21) et le plan de soudure froide (25) comprenant les soudures les plus froides de l'étage de thermopile (21) ne s'écarte pas de plus de 50 %, de préférence pas de plus de 20 %, mieux pas de plus de 10 %, encore mieux pas de plus de 5 % de la résistance thermique de l'environnement ($R_{th,amb}$), qui est la somme de la résistance thermique de la source de chaleur, de la résistance thermique du puits de chaleur et de la résistance thermique de toutes les parties du générateur thermoélectrique (49) couplées en série à l'au moins un étage de thermopile (21), multipliée par la résistance thermique parasite ($R_{TEG,0,1}$) entre le plan de soudure chaude (24) et le plan de soudure froide (25) pour un même générateur thermoélectrique, mais ne comprenant aucun thermocouple (10) ou seulement une branche de thermocouple (11, 12), ce produit étant divisé par la somme de la résistance thermique parasite ($R_{TEG,0,1}$) entre le plan de soudure chaude (24) et le plan de soudure froide (25) pour un même générateur thermoélectrique, mais ne comprenant aucun thermocouple (10) ou seulement une branche de thermocouple (11, 12), sommé avec deux fois la résistance thermique de l'environnement ($R_{th,0,1,amb}$), pour un même générateur thermoélectrique mais ne comprenant aucun thermocouple (10) ou seulement une branche de thermocouple (11, 12).

**2.** Générateur thermoélectrique (49) selon la revendication 1, dans lequel au moins dudit au moins un étage de thermopile (21) comprend au moins une d'une première plaque (22) thermiquement reliée aux soudures dans ledit plan de soudure chaude (24) et d'une seconde plaque (23) thermiquement reliée aux soudures dans ledit plan de soudure froide (25).

3. Générateur thermoélectrique (49) selon la revendication 1 ou 2, dans lequel ladite unité formant thermopile (50) est thermiquement reliée à et positionnée entre une plaque chaude (37) pour connexion à la source de chaleur et une plaque froide (38) pour connexion au puits de chaleur.

4. Générateur thermoélectrique (49) selon la revendication 3, ledit générateur thermoélectrique (49) comprenant en outre un radiateur (48) monté sur ou placé à la place de la plaque froide (38).

5. Générateur thermoélectrique (49) selon la revendication 3 ou 4, dans lequel la superficie de la plaque chaude (37) est plus grande que la surface de l'unité formant thermopile (50), la surface de l'unité formant thermopile (50) étant déterminée dans un plan parallèle à la plaque chaude (37) et/ou dans lequel la superficie de la plaque froide (38) est plus grande que la surface de l'unité formant thermopile (50), la surface de l'unité formant thermopile (50) étant déterminée dans un plan parallèle à la plaque froide (38).

6. Générateur thermoélectrique (49) selon l'une quelconque des revendications précédentes, comprenant en outre au moins une pièce d'écartement thermiquement conductrice (52, 53) entre l'au moins un étage de thermopile (21) et la plaque chaude (37) et/ou la plaque froide (38) et/ou le radiateur (48) et/ou entre deux des au moins un étages de thermopile (21).

7. Générateur thermoélectrique (49) selon l'une quelconque des revendications précédentes, dans lequel l'unité formant thermopile (50) comprend plus d'un étage de thermopile (21) pour améliorer le nombre de Rayleigh ou le nombre de Reynolds du transfert de chaleur au niveau de la surface de la plaque froide (38) ou au niveau de la surface du radiateur (48) en comparaison au même générateur thermoélectrique (49) avec un seul étage de thermopile (21).

8. Générateur thermoélectrique (49) selon la revendication 3 à la revendication 7, ledit générateur thermoélectrique (49) comprenant en outre un réflecteur thermique (60) positionné entre la plaque chaude (37) et la plaque froide (38), ledit réflecteur thermique (60) recouvrant la plaque chaude (37), la plaque froide (38), le radiateur (48), la première plaque (22) et/ou la seconde plaque (23) et étant thermiquement isolé de ceux-ci.

9. Générateur thermoélectrique (49) selon l'une quelconque des revendications précédentes, dans lequel lesdits thermocouples sont des thermocouples micro-usinés.

10. Générateur thermoélectrique (49) selon l'une quelconque des revendications précédentes, dans lequel lesdits thermocouples (10) sont positionnés sur une membrane ou sur une bande de polymère, ou dans lequel des thermocouples à film mince / épais (10) sans substrat sont utilisés.

11. Générateur thermoélectrique (49) selon l'une quelconque des revendications précédentes, dans lequel au moins un dudit au moins un étage de thermopile (21) comprend une structure thermiquement conductrice formant une interconnexion thermique entre les branches de thermocouple (11, 12) et au moins un de la plaque froide (37), de la plaque chaude (38) et du radiateur (48), ladite structure thermiquement conductrice comprenant un film mince / épais de matière thermiquement conductrice ou d'une matière de substrat.

12. Générateur thermoélectrique (49) selon l'une quelconque des revendications précédentes, dans lequel ledit générateur thermoélectrique (49) est rempli au moins partiellement avec une matière thermiquement isolante.

13. Générateur thermoélectrique (49) selon l'une quelconque de la revendication 3 à la revendication 12, dans lequel le volume intérieur dudit générateur thermoélectrique (49) est encapsulé sur son périmètre entre la plaque chaude (37) et la plaque froide (38) ou le radiateur (48), en utilisant une couche de matière thermiquement isolante.

14. Générateur thermoélectrique (49) selon la revendication 13, dans lequel le volume entre la plaque chaude (37) et la plaque froide (38) ou le radiateur (48) est rempli d'un gaz ayant une conductibilité thermique plus basse que l'air ou qui est à une pression qui est inférieure à la pression atmosphérique.

15. Générateur thermoélectrique (49) selon l'une quelconque des revendications 3 à 14, dans lequel la surface intérieure de ladite plaque chaude (37) ou la surface intérieure dudit réflecteur thermique (60), qui est la surface ne faisant pas face à la source de chaleur, a une faible émissivité, de préférence inférieure à 20 %, mieux inférieure à 10 %, dans la plage infrarouge, et dans lequel la surface intérieure de ladite plaque froide (38) ou la surface intérieure dudit radiateur (48), qui est la surface ne faisant pas face au puits de chaleur, a une émissivité élevée, de préférence supérieure à 90 %, mieux supérieure à 95 %, dans la plage infrarouge.

16. Procédé pour concevoir un générateur thermoélectrique (49) pour connexion entre une source de chaleur et un puits de chaleur et avec un flux de chaleur limité à travers le générateur thermoélectrique (49) et une différence de température non constante entre la source de chaleur et le puits de chaleur, le générateur thermoélectrique (49) comprenant une unité formant thermopile (50), ladite unité formant thermopile (50) comprenant au moins un étage de thermopile (21), chaque étage de thermopile comprenant un certain nombre de thermocouples (10) chacun ayant un couple de branches de thermocouple (11, 12), les branches de thermocouple (11, 12) étant disposées entre un plan de soudure chaude (24) comprenant les soudures les plus chaudes d'un étage de thermopile (21) et un plan de soudure froide (25) comprenant les soudures les plus froides d'un étage de thermopile (21), le procédé comprenant :

   la détermination de la résistance thermique ($R_{TEG}$) du générateur thermoélectrique (49) entre le plan de soudure chaude (24) et le plan de soudure froide (25) comme une fonction du nombre de thermocouples (10) ; la détermination de la somme ($R_{th,amb}$) de la résistance thermique de la source de chaleur, de la résistance thermique du puits de chaleur et de la résistance thermique de toutes les parties du générateur thermoélectrique couplées en série à l'au moins un étage de thermopile (21), comme une fonction du nombre de thermocouples (10) ;
   la détermination de la résistance thermique parasite ($R_{TEG,0,1}$) entre le plan de soudure chaude (24) et le plan de soudure froide (25) pour un même générateur thermoélectrique mais ne comprenant aucun thermocouple (10) ou seulement une branche de thermocouple (11, 12) ;
   la détermination de la somme ($R_{th,0,1,amb}$) de la résistance thermique de la source de chaleur, de la résistance thermique de puits de chaleur et de la résistance thermique de toutes les parties du générateur thermoélectrique couplées en série à l'au moins un étage de thermopile (21), pour un même générateur thermoélectrique, mais ne comprenant aucun thermocouple (10) ou seulement une branche de thermocouple (11, 12) ;
   la division du produit de $R_{th,amb}$ et de $R_{TEG,0,1}$ par la somme de $R_{TEG,0,1}$ et de deux fois $R_{th,0,1,amb}$, aboutissant à une valeur de résistance thermique ; et
   l'adaptation du nombre de thermocouples (10) de sorte que la résistance thermique ($R_{TEG}$) du générateur thermoélectrique (49) entre le plan de soudure chaude (24) et le plan de soudure froide (25) ne s'écarte pas de plus de 50 %, de préférence pas de plus de 20 %, mieux pas de plus de 10 %, encore mieux pas de plus de 5 % de ladite valeur de résistance thermique.

17. Procédé pour concevoir un générateur thermoélectrique (49) selon la revendication 16, dans lequel ladite unité formant thermopile (50) est thermiquement reliée à et positionnée entre une plaque chaude (37) pour connexion à la source de chaleur et une plaque froide (38) pour connexion au puits de chaleur.

18. Procédé pour concevoir un générateur thermoélectrique (49) selon la revendication 17, dans lequel le générateur thermoélectrique comprend un radiateur (48) monté sur ou placé à la place de la plaque froide (38).

19. Procédé pour concevoir un générateur thermoélectrique (49) selon l'une quelconque des revendications 16 à 18, comprenant en outre la variation de la forme et/ou de la taille d'au moins un de la plaque chaude (37) et de la plaque froide (38) et du radiateur (48).

20. Procédé pour concevoir un générateur thermoélectrique (49) selon l'une quelconque des revendications 16 à 19, dans lequel le générateur thermoélectrique (49) comprend au moins une pièce d'écartement thermiquement conductrice (52, 53) entre l'au moins un étage de thermopile (21) et la plaque chaude (37) et/ou la plaque froide (38) et/ou le radiateur (48) et/ou entre deux des étages de thermopile (21).

21. Produit formant programme informatique pour exécuter un procédé pour concevoir un générateur thermoélectrique selon l'une quelconque des revendications 16 à 20.

22. Dispositif de stockage de données, pouvant être lu par une machine, stockant le produit formant programme informatique de la revendication 21.

23. Transmission du produit formant programme informatique de la revendication 21 sur un réseau de télécommunications local ou étendu.

24. Utilisation du générateur thermoélectrique (49) selon l'une quelconque de la revendication 1 à la revendication 15, dans laquelle ladite source de chaleur est un animal, un être humain, un être humain habillé ou de l'air ambiant et dans laquelle ledit puits de chaleur est de l'air ambiant, un animal, un être humain ou un être humain habillé.

25. Utilisation du générateur thermoélectrique (49) selon l'une quelconque de la revendication 1 à la revendication 15, dans laquelle ladite source de chaleur est un objet spatial ou un objet spatial artificiel et dans laquelle ledit puits de chaleur est l'espace interplanétaire, un objet spatial ou un objet spatial artificiel.

26. Utilisation du générateur thermoélectrique (49) selon l'une quelconque de la revendication 1 à la revendication 15, dans laquelle ladite source de chaleur est un objet rayonnant distant ou une pluralité d'objets rayonnant distants comme des objets spatiaux ou des objets ambiants et dans laquelle le puits de chaleur est la surface de la Terre.

10

13

11    12

13    13

a

a

# Fig. 1 – PRIOR ART

20

23    25

24

22

13  11    10  12

# Fig. 2 – PRIOR ART

## Fig. 3.a          Fig. 3.b
## PRIOR ART

## Fig.4 – PRIOR ART

**Fig.5 – PRIOR ART**

**Fig.6 – PRIOR ART**

**Fig.7 – PRIOR ART**

**Fig.8 – PRIOR ART**

## Fig.9 – PRIOR ART

## Fig.10 – PRIOR ART

**Fig.11 – PRIOR ART**

**Fig.12 – PRIOR ART**

$P_{out} / P_{out,max}$

$R_{th,tp} / R_{th,\,air\,in}$

## Fig.13 – PRIOR ART

49

38

50

51

51

37

## Fig.14

**Fig.15**

**Fig.16**

11, 12

38

37

51

50, 51

**Fig.17**

Wrist

37

53

21

38

Free convection

**Fig.18**

**Fig.19**

**Fig.20**

**Fig.21**

**Fig.22**

**Fig.23**

**Fig.24**

**Fig.25**

**Fig.26**

**Fig.27**

**Fig.28**

**Fig.29**

**Fig.30**

**Fig.31**

**Fig.32**

**Fig.33**

**Fig.34**

**Fig.35**

**Fig.36**

# Fig.37

# Fig.38

## Fig.39

## Fig.40

**Fig.41**

**Fig.42**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2004105143 A1, Ingo Stark and P. Zhou
- US 6958443 B, Ingo Stark

- EP 1612870 A

**Non-patent literature cited in the description**

- **M. KISHI ; H. NEMOTO ; T. HAMAO ; M. YAMAMOTO ; S. SUDOU ; M. MANDAI ; S. YAMAMOTO.** Micro-Thermoelectric Modules and Their Application to Wristwatches as an Energy Source. *Proceedings ICT'99 18th Int. Conference on Thermoelectrics,* 1999, 301-307
- **M. STRASSER ; R. AIGNER ; C. LAUTERBACH ; T.F. STURM ; M. FRANOSCH ; G. WACHUTKA.** Micromachined CMOS Thermoelectric Generators as On-chip Power Supply. *Transducers '03. 12th International Conference on Solid State Sensors, Actuators and Microsystems,* 2003, 45-48
- **A. JACQUOT ; W.L. LIU ; G. CHEN ; J.-P. FLEURIAL ; A. DAUSHER ; B. LENOIR.** Fabrication and modeling of an in-plane thermoelectric micro-generator. *Proceedings ICT '02. 21st International Conference on Thermoelectrics,* 2002, 561-564
- **H. BÖTTNER ; J. NUMUS ; A. GAVRIKOV ; G. KÜHNER ; M. JÄGLE ; C. KÜNZEL ; D. EBERHARD ; G. PLESCHER ; A. SCHUBERT ; K.-H. SCHLERETH.** New Thermoelectric Components using Microsystem Technologies. *Journal of Microelectromechanical Systems,* 2004, vol. 13 (3), 414-420
- **S. HASEBE ; J. OGAWA ; M. SHIOZAKI ; T. TORIYAMA ; S. SUGIYAMA ; H. UENO ; K. ITOIGAWA.** Polymer based smart flexible thermopile for power generation. *17th IEEE Int. Conf. Micro Electro Mechanical Systems (MEMS,* 2004, 689-692
- **I. STARK ; M. STORDEUR.** New micro thermoelectric devices based on bismuth telluride-type thin solid films. *Proceeding of the 18th International Conference on Thermoelectrics (ICT,* 1999, 465-472

- **I. STARK.** Thermal Energy Harvesting with Thermo Life. *Proceedings of International Workshop on Wearable and Implantable Body Sensor Networks (BSN'06,* 2006
- **V. LEONOV ; P. FIORINI ; S. SEDKY ; T. TORFS ; C. VAN HOOF.** Thermoelectric MEMS generators as a power supply for a body area network. *Proceedings of the 13th International Conference on Solid-State Sensors, Actuators and Microsystems (Transducers'05,* 2005, 291-294
- **M. KISHI ; H. NEMOTO ; T. HAMAO ; M. YAMAMOTO ; S. SUDOU ; M. MANDAI ; S. YAMAMOTO.** Micro-Thermoelectric Modules and Their Application to Wristwatches as an Energy Source. *Proceedings ICT'99 18th International Conference on Thermoelectrics,* 301-307
- **M. STRASSER ; R. AIGNER ; C. LAUTERBACH ; T. STURM ; M. FRANOSCH ; G. WACHUTKA.** Micromachined CMOS Thermoelectric Generators as On-chip Power Supply. *Transducers '03, 12th International Conference on Solid State Sensors, Actuators and Microsystems,* 2003, 45-48
- **H. BÖTTNER ; A. SCHUBERT ; K. SCHLERETH ; D. EBERHARD ; A. GAVRIKOV ; M. JÄGLE ; G. KÜHNER ; C. KUNZEL ; J. NURNUS ; G. PLESCHER.** New Thermoelectric Components using Micro-System-Technologies. *ETS 2001 - 6th European Workshop on Thermoelectrics,* 2001
- **H. BÖTTNER.** Thermoelectric Micro Devices: Current State, Recent Developments and future Aspects for Technological Progress and Applications. *Proceedings of the 21st International Conference on Thermoelectrics,* 2002, 511-518